(19) **Europäisches Patentamt / European Patent Office / Office européen des brevets**

(11) **EP 3 871 876 A1**

(12) **EUROPEAN PATENT APPLICATION**
published in accordance with Art. 153(4) EPC

(43) Date of publication:
01.09.2021 Bulletin 2021/35

(21) Application number: 19876264.3

(22) Date of filing: 18.10.2019

(51) Int Cl.:
$B32B\ 9/00^{(2006.01)}$ $C23C\ 16/42^{(2006.01)}$

(86) International application number:
PCT/JP2019/041168

(87) International publication number:
WO 2020/085248 (30.04.2020 Gazette 2020/18)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 23.10.2018 JP 2018199544

(71) Applicant: SUMITOMO CHEMICAL COMPANY
LIMITED
Chuo-ku
Tokyo 104-8260 (JP)

(72) Inventors:
• **YAMAKAWA, Shohei**
Niihama-shi, Ehime 792-0015 (JP)
• **YAMASHITA, Yasuhiro**
Niihama-shi, Ehime 792-0015 (JP)
• **OZEKI, Miho**
Tsukuba-shi, Ibaraki 300-3294 (JP)
• **HANAOKA, Hidenori**
Osaka-shi, Osaka 554-8558 (JP)
• **ARIMURA, Takashi**
Tsukuba-shi, Ibaraki 300-3294 (JP)

(74) Representative: **J A Kemp LLP**
**14 South Square**
**Gray's Inn**
**London WC1R 5JJ (GB)**

(54) **LAMINATED BODY, FLEXIBLE ELECTRONIC DEVICE, AND LAMINATED-BODY MANUFACTURING METHOD**

(57) The present disclosure relates to a laminated body including at least a base material layer containing at least a flexible base material and an inorganic thin film layer, in which a distribution curve of $I_{O2}/I_{Si}$ has at least one maximum value $(I_{O2}/I_{Si})_{maxBD}$ in a region BD between a depth B and a depth D, where ionic strengths of $Si^-$, $C^-$, and $O_2^-$ are each denoted as Isi, Ic, and $I_{O2}$ in a depth profile measured from a surface of the laminated body on an inorganic thin film layer side in a thickness direction using a time-of-flight secondary ion mass spectrometer (TOF-SIMS), an average ionic strength in a region A1 in which an absolute value of a coefficient of variation of an ionic strength value on a base material layer side is within 5% is denoted as $I_{CA1}$, a depth that is closest to the region A1 on a surface side of the inorganic thin film layer with respect to the region A1 and exhibits an ionic strength to be 0.5 times or less the $I_{CA1}$ is denoted as A2, and a depth that is closest to A2 on a surface side of the inorganic thin film layer with respect to A2 and exhibits a minimum value is denoted as A3 in an ionic strength curve of $C^-$, and a depth that is closest to A3 on a surface side of the inorganic thin film layer with respect to A3 and has a differential value of 0 or more is denoted as B, a depth that is closest to A3 on a base material layer side with respect to A3 and exhibits a maximum value $d(I_C)_{max}$ of differential distribution value is denoted as C, and a depth that is closest to C on a base material layer side with respect to C and has an absolute value of differential value to be 0.01 times or less the $d(I_C)_{max}$ is denoted as D in a first-order differential curve of ionic strength of $C^-$.

EP 3 871 876 A1

Fig. 5

Example 1

**Description**

TECHNICAL FIELD

The present disclosure relates to a laminated body having at least a base material layer containing at least a flexible base material and an inorganic thin film layer, a flexible electronic device including the laminated body, and a method for manufacturing the laminated body.

BACKGROUND ART

Laminated bodies to which gas barrier property is imparted are widely used in packaging applications of foods, industrial supplies, pharmaceuticals and the like. In recent years, in flexible substrates for solar cells and electronic devices such as organic EL displays, and the like, there is a demand for laminated bodies exhibiting further improved gas barrier property as compared with the laminated bodies for food applications and the like. In order to enhance the gas barrier property of such laminated bodies, laminated bodies in which a thin film layer is further laminated on a base material layer having an organic layer on a flexible base material formed of polyethylene terephthalate (PET) have been studied (for example, Patent Documents 1 and 2).

PRIOR ART DOCUMENTS

PATENT DOCUMENTS

Patent Document 1: JP-A-2016-68383
Patent Document 2: WO 2013/146964 A

DISCLOSURE OF THE INVENTION

PROBLEMS TO BE SOLVED BY THE INVENTION

According to the studies by the present inventors, it has been found that the adhesive property between layers may decrease due to bending in a case in which such laminated bodies are transported by a roll-to-roll process and in a case in which such laminated bodies are used in a flexible substrate and the like. When the adhesive property decreases and peeling off occurs between the layers, a decrease in gas barrier property, a decrease in optical properties, and the like may be caused.

Hence, an object of an embodiment of the present invention is to provide a laminated body in which the adhesive property between a base material layer and an inorganic thin film layer is excellent, in particular, a laminated body in which the adhesive property between a base material layer and an inorganic thin film layer is excellent after a bending resistance test.

MEANS FOR SOLVING THE PROBLEMS

In order to achieve the object, the present inventors have focused on the boundary portion between the base material layer and the inorganic thin film layer and diligently conducted studies. As a result, it has been found out that a laminated body which solves the above problems can be obtained in a case in which the depth profile of a laminated body measured using a time-of-flight secondary ion mass spectrometer (TOF-SIMS) has predetermined features, that is, in a case in which there is a region in which the abundance of $SiO_x$ is high at the boundary portion between the base material layer and the inorganic thin film layer, and the present disclosure has been thus completed.

In other words, the present disclosure includes the following suitable aspects.

[1] A laminated body including at least a base material layer containing at least a flexible base material and an inorganic thin film layer, in which a distribution curve of $I_{O2}/I_{Si}$ has at least one maximum value $(I_{O2}/I_{Si})_{maxBD}$ in a region BD between a depth B and a depth D, where

ionic strengths of $Si^-$, $C^-$, and $O_2$ are each denoted as $I_{Si}$, $I_C$, and $I_{O2}$ in a depth profile measured from a surface of the laminated body on an inorganic thin film layer side in a thickness direction using a time-of-flight secondary ion mass spectrometer (TOF-SIMS),

an average ionic strength in a region A1 in which an absolute value of a coefficient of variation of an ionic strength value on a base material layer side is within 5% is denoted as $I_{CA1}$, a depth that is closest to the region A1 on a surface side of the inorganic thin film layer with respect to the region A1 and exhibits an ionic strength to be 0.5 times or less the $I_{CA1}$ is denoted as A2, and a depth that is closest to A2 on a surface side of the inorganic thin film layer with respect to A2 and exhibits a minimum value is denoted as A3 in an ionic strength curve of $C^-$, and

a depth that is closest to A3 on a surface side of the inorganic thin film layer with respect to A3 and has a differential value of 0 or more is denoted as B, a depth that is closest to A3 on a base material layer side with respect to A3 and exhibits a maximum value $d(I_C)_{max}$ of differential distribution value is denoted as C, and a depth that is closest to C on a base material layer side with respect to C and has an absolute value of differential value to be 0.01 times or less the $d(I_C)_{max}$ is denoted as D in a first-order differential curve of ionic strength of $C^-$.

[2] The laminated body according to [1], in which the maximum value $(I_{O2}/I_{Si})_{maxBD}$ is 0.4 or more.

[3] The laminated body according to [1] or [2], in which a standard deviation of $I_{O2}/I_{Si}$ is 0.07 or less in a region EB between a depth E and a depth B in a distribution curve of $I_{O2}/I_{Si}$, where a depth at 5 nm on the base material layer side from an outermost surface on the inorganic thin film layer side is denoted as E.

[4] The laminated body according to any one of [1] to [3], in which a distribution curve of $I_C/I_{Si}$ has at least one minimum value $(I_C/I_{Si})_{minBD}$ in a region BD between a depth B and a depth D.

[5] The laminated body according to any one of [1] to [4], in which the minimum value $(I_C/I_{Si})_{minBD}$ is 0.8 or less.

[6] The laminated body according to any one of [1] to [5], in which a standard deviation of $I_C/I_{Si}$ is 0.15 or less in a region EB between a depth E and the depth B of the distribution curve of $I_C/I_{Si}$.

[7] The laminated body according to any one of [1] to [6], in which a distance between a depth exhibiting the maximum value $(I_{O2}/I_{Si})_{maxBD}$ and a depth exhibiting the minimum value $(I_C/I_{Si})_{minBD}$ is 0.7 times or less a distance of the region BD.

[8] A laminated body including at least a base material layer containing at least a flexible base material and a layer containing a component having a urethane bond and an inorganic thin film layer, in which a distribution curve of $I_{O2}/I_{Si}$ has at least one maximum value $(I_{O2}/I_{Si})_{maxGH}$ in a region GH between a depth G and a depth H, where ionic strengths of $CN^-$, $Si^-$, $C^-$, and $O_2^-$ are each denoted as $I_{CN}$, $I_{Si}$, $I_C$, and $I_{O2}$ in a depth profile measured from a surface of the laminated body on an inorganic thin film layer side in a thickness direction using a time-of-flight secondary ion mass spectrometer (TOF-SIMS), and

a depth that exhibits a maximum value $d(I_{CN})_{max}$ of differential distribution value is denoted as F, a depth that is closest to F on a surface side of the inorganic thin film layer with respect to F and has an absolute value of differential value to be 0.01 times or less the maximum value $d(I_{CN})_{max}$ is denoted as G, and a depth that is closest to F on a base material layer side with respect to F and has an absolute value of differential value to be 0.01 times or less the maximum value $d(I_{CN})_{max}$ is denoted as H in a first-order differential curve of ionic strength of $CN^-$.

[9] The laminated body according to [8], in which the maximum value $(I_{O2}/I_{Si})_{maxGH}$ is 0.4 or more.

[10] The laminated body according to [8] or [9], in which a standard deviation of $I_{O2}/I_{Si}$ is 0.07 or less in a region EJ between a depth E and a depth J in a distribution curve of $I_{O2}/I_{Si}$, where a depth at 5 nm on the base material layer side from an outermost surface on the inorganic thin film layer side is denoted as E and a depth that is separated from the depth G toward the surface side of the inorganic thin film layer at a distance equal to a distance between the depth G and the depth H is denoted as J.

[11] The laminated body according to any one of [8] to [10], in which a distribution curve of $I_C/I_{Si}$ has at least one minimum value $(I_C/I_{Si})_{minGH}$ in a region GH between the depth G and the depth H.

[12] The laminated body according to [11], in which the minimum value $(I_C/I_{Si})_{minGH}$ is 0.8 or less.

[13] The laminated body according to any one of [8] to [12], in which a standard deviation of $I_C/I_{Si}$ is 0.15 or less in a region EJ between the depth E and the depth J of the distribution curve of $I_C/I_{Si}$.

[14] The laminated body according to any one of [8] to [13], in which a distance between a depth exhibiting the maximum value $(I_{O2}/I_{Si})_{maxGH}$ and a depth exhibiting the minimum value $(I_C/I_{Si})_{minGH}$ is 0.7 times or less a distance of the region GH.

[15] A flexible electronic device including the laminated body according to any one of [1] to [14].

[16] A method for manufacturing the laminated body according to any one of [1] to [14], the method including at least a step of forming an inorganic thin film layer on a base material by supplying a deposition gas to a space between a first deposition roll and a second deposition roll that are disposed in a vacuum chamber to generate discharge plasma while transporting the base material using the first deposition roll and the second deposition roll, in which a first magnetic field forming apparatus is disposed in each deposition roll of the first deposition roll and the second deposition roll and one or more additional magnetic field forming apparatuses are disposed at a position separated from a deposition gas supply portion farther than the first magnetic field forming apparatus.

EFFECT OF THE INVENTION

According to an embodiment of the present invention, there is provided a laminated body in which the adhesive property between a base material layer and an inorganic thin film layer is excellent.

BRIEF DESCRIPTION OF THE DRAWINGS

Fig. 1 is a diagram illustrating an ionic strength curve of $C^-$ of a laminated body of Example 1.
Fig. 2 is a diagram illustrating a first-order differential curve of ionic strength curve of $C^-$ of a laminated body of Example 1.
Fig. 3 is a diagram illustrating a first-order differential curve of ionic strength curve of $CN^-$ of a laminated body of Example 1.
Fig. 4 is a diagram illustrating distribution curves of $I_{O2}/I_{Si}$ and $I_C/I_{Si}$ of a laminated body of Example 1.
Fig. 5 is a diagram illustrating distribution curves of $I_{O2}/I_{Si}$ and $I_C/I_{Si}$ of a laminated body of Example 1.
Fig. 6 is a schematic view illustrating a laminated film manufacturing apparatus used in Examples and Comparative Examples.
Fig. 7 is a diagram illustrating an ionic strength curve of $C^-$ of a laminated body of Example 2.
Fig. 8 is a diagram illustrating a first-order differential curve of ionic strength curve of $C^-$ of a laminated body of Example 2.
Fig. 9 is a diagram illustrating a first-order differential curve of ionic strength curve of $CN^-$ of a laminated body of Example 2.
Fig. 10 is a diagram illustrating distribution curves of $I_{O2}/I_{Si}$ and $I_C/I_{Si}$ of a laminated body of Example 2.
Fig. 11 is a diagram illustrating an ionic strength curve of $C^-$ of a laminated body of Comparative Example 1.
Fig. 12 is a diagram illustrating a first-order differential curve of ionic strength curve of $C^-$ of a laminated body of Comparative Example 1.
Fig. 13 is a diagram illustrating a first-order differential curve of ionic strength curve of $CN^-$ of a laminated body of Comparative Example 1.
Fig. 14 is a diagram illustrating distribution curves of $I_{O2}/I_{Si}$ and $I_C/I_{Si}$ of a laminated body of Comparative Example 1.

MODE FOR CARRYING OUT THE INVENTION

Hereinafter, several embodiments of the present invention will be described in detail. It should be noted that the scope of the present invention is not limited to the embodiments described here and various changes can be made without departing from the gist of the present invention.

In an embodiment of the present invention, the laminated body is a laminated body including at least a base material layer containing at least a flexible base material and an inorganic thin film layer, and the laminated body has at least one maximum value $(I_{O2}/I_{Si})_{maxBD}$ or maximum value $(I_{O2}/I_{Si})_{maxGH}$ in the region BD or region GH determined by the method to be described later in the depth profile measured from the surface of the laminated body on the inorganic thin film layer side in the thickness direction using a time-of-flight secondary ion mass spectrometer (hereinafter, also referred to as "TOF-SIMS"). In the following, the maximum value $(I_{O2}/I_{Si})_{maxBD}$ and the maximum value $(I_{O2}/I_{Si})_{maxGH}$ are collectively referred to as the maximum value $(I_{O2}/I_{Si})_{max}$. The region BD and region GH are considered to be a part of the region included in the inorganic thin film layer of the laminated body according to an embodiment of the present invention and to be regions adjacent to the interface between the inorganic thin film layer and the base material layer. The region BD and region GH are each regions determined by the methods to be described later and the designated regions are considered to be approximately the same region in the laminated body although the methods for designating the regions differ from each other. The fact that the distribution curve of $I_{O2}/I_{Si}$ has at least one maximum value $(I_{O2}/I_{Si})_{max}$ in this region BD or region GH indicates that there is a portion where the ratio of the ionic strength of $Si^-$ to the ionic strength of $O_2^-$ changes at a part of the region that is adjacent to the interface between the inorganic thin film layer and the base material layer and is included in the inorganic thin film layer of the laminated body. In particular, the fact that the ratio of the ionic strength of $O_2^-$ to the ionic strength of $Si^-$ has a maximum value indicates that there is a portion where the amount of $O_2^-$ is larger than that of $Si^-$ in a part of the inorganic thin film layer region adjacent to the interface between the inorganic thin film layer and the base material layer. As such a region exists in the vicinity of the interface between the inorganic thin film layer and the base material layer, it has been found that the adhesive property between the inorganic thin film layer and the base material layer is enhanced and a decrease in gas barrier property and a decrease in optical properties caused by bending can be suppressed although the reason is not clear. It is considered that this is because the location where the amount of $O_2^-$ is larger than that of $Si^-$ in the entire inorganic thin film layer has a small internal stress and acts as a stress relaxation layer although the reason is not limited to the following mechanism at all. It is considered that this is because the damage to the interface due to bending can be reduced while maintaining high gas barrier property as such a location exists in the vicinity of the interface between the inorganic thin film layer and the base material layer.

Time-of-flight secondary ion mass spectrometry (TOF-SIMS) is a kind of mass spectrometry. According to TOF-SIMS, the element or molecular species existing on the outermost surface of the sample can be acquired with an extremely high detection sensitivity and the distribution of elements or molecular species existing on the outermost surface of the sample can also be investigated.

TOF-SIMS is a method for irradiating a sample with an ion beam (primary ion) in a high vacuum and performing mass separation of the ions released from the surface by utilizing the difference in time of flight. When the sample is irradiated with primary ions, positively or negatively charged ions (secondary ions) are released from the sample surface, but lighter ions fly faster and heavier ions fly slower, and thus the mass of the generated secondary ions can be calculated if the time (time of flight) from generation to detection of the secondary ions is measured. A mass spectrum can be acquired by graphing the number and mass of the generated secondary ions. Examples of the instrument used for TOF-SIMS include "TOF.SIMS V" manufactured by IONTOF GmbH. In an embodiment of the present invention, the ionic strengths of $Si^-$, $C^-$, and $O_2^-$ and optionally the ionic strength of $CN^-$ are measured.

In the mass spectrum acquired through the measurement by TOF-SIMS, C ions are detected in the vicinity of a mass of 12.00u, CN ions are detected in the vicinity of a mass of 26.00u, Si ions are detected in the vicinity of a mass of 27.98u, and $O_2$ ions are detected in the vicinity of a mass of 32.00u. These ions are ions that are detected in both positive ion analysis and negative ion analysis. The measurement conditions by TOF-SIMS are not particularly limited, but conditions using negative ion analysis are preferable from the viewpoint of obtaining a higher detection sensitivity.

By utilizing the sputtering technology in combination with the measurement by TOF-SIMS, it is also possible to perform depth direction analysis. By repeating the process of sputtering with sputtered ions and the process of acquiring the mass spectrum by TOF-SIMS and acquiring a depth profile, it is possible to analyze the distribution state and layer separation state of the constituent components from the film surface to the depth direction.

The measurement in the depth direction of the inorganic thin film layer is required to be started from the outermost surface in a state of not having dirt and foreign matters attached thereto. The portion from the outermost surface on the inorganic thin film layer side to 5 nm is a portion into which ions are likely to be mixed depending on the conditions when the inorganic thin film layer is formed and the like or which is easily affected by the external atmosphere. For this reason, the region from the outermost surface on the inorganic thin film layer side to 5 nm in the depth direction is removed by sputtering, and then the measurement by TOF-SIMS is performed. The measurement is performed by repeating sputtering and measurement at predetermined measurement intervals until the flexible base material contained in the base material layer adjacent to the inorganic thin film layer or the clear hard coat layer laminated on the surface of the flexible base material is exposed.

The measurement interval is preferably 0.5 to 60 seconds, more preferably 0.5 to 30 seconds as the sputtering time. The measurement interval is preferably as short as possible from the viewpoint of diminishing the analysis interval in the thickness direction and performing the analysis with a higher accuracy. An example of specific analysis conditions by TOF-SIMS is as presented in Examples.

In an embodiment of the present invention, the depth profile by TOF-SIMS measured from the surface of the laminated body on the inorganic thin film layer side in the thickness direction is an ionic strength curve acquired by measuring the ionic strength at the depths (distances from the surface of the inorganic thin film layer) from the outermost surface of the inorganic thin film layer in the thickness direction in the order of the inorganic thin film layer surface where the measurement is started, the inorganic thin film layer, the interface between the inorganic thin film layer and the base material layer, and the base material layer. The ionic strength curve is a curve taking the number of sputterings relatively corresponding to the depth in the thickness direction as the horizontal axis and the ionic strength as the vertical axis.

In the present specification, the "extreme value" represents a maximum value or a minimum value in the ionic strength curve. In the present specification, the "maximum value" means a point where the value of ionic strength changes from an increase to a decrease in the ionic strength curve. The "maximum value" is, in other words, an extreme value of upward convex. In the present specification, the "minimum value" means a point where the value of ionic strength changes from a decrease to an increase in the ionic strength curve. The "minimum value" is, in other words, an extreme value of downward convex. Although the above description relates to the ionic strength curve, the above description is similarly applied in the first-order differential curve by replacing the ionic strength in the above description with a differential value.

Here, when the maximum value and the minimum value are specified and the depth is acquired, there is a case in which it is difficult to easily specify the maximum value and the minimum value since noise is included in the ionic strength curve or the like. In that case, the maximum value and the minimum value may be specified according to the following criteria.

Maximum value: In order to judge whether or not a specific point M (Mth point) is the maximum value, plots of 11 consecutive points centered on the point M are first extracted. In other words, five plots (M-5, M-4, M-3, M-2, and M-1st points in order from the surface side) positioned on the surface side of the inorganic thin film layer with respect to the point M and five plots (M+1, M+2, M+3, M+4, M+5th points in order from the surface side) positioned on the base material layer side with respect to the point M are extracted. In a case in which these consecutive M-5th to M+5th points satisfy the following (1), any of (2-1) to (2-3), and any of (3-1) to (3-3), the point M may be judged to be the maximum value. The ionic strength value or the differential value may be simply referred to as the "value" in the following description.

(1) The value at the point M is greater than the value at any of M-5 to M-1 and M+1 to M+5.
(2) When the increase or decrease in value when the plot number increases by 1 is evaluated for the M-5 to M-1st plots,
(2-1) The value increases monotonically from M-5 to M-1 (there are four plots of which the value increases when the plot number increases by 1),
(2-2) When the plot number increases by 1, there are three plots of which the value increases, there is one plot of which the value does not change or decreases, and the amount of decrease in value is 80% or less of the difference between the value at the point M and the smallest value among the values at the plots M-5 to M-1 in a case in which the value decreases, or
(2-3) When the plot number increases by 1, there are two plots of which the value increases, there is two plots of which the value does not change or decreases, and the amount of decrease in value is 60% or less of the difference between the value at the point M and the smallest value among the values at the plots M-5 to M-1 in a case in which the value decreases.
(3) When the increase or decrease in value when the plot number increases by 1 is evaluated for the M+1 to M+5th plots,
(3-1) The value decreases monotonically from M+1 to M+5 (there are four plots of which the value decreases when the plot number increases by 1),
(3-2) When the plot number increases by 1, there are three plots of which the value decreases, there is one plot of which the value does not change or increases, and the amount of increase in value is 80% or less of the difference between the value at the point M and the smallest value among the values at the plots M+1 to M+5 in a case in which the value increases, or
(3-3) When the plot number increases by 1, there are two plots of which the value decreases, there is two plots of which the value does not change or increases, and the amount of increase in value is 60% or less of the difference between the value at the point M and the smallest value among the values at the plots M+1 to M+5 in a case in which the value increases.
Minimum value: In order to judge whether or not a specific point N (Nth point) is the minimum value, plots of 11 consecutive points centered on the point N are first extracted. In other words, five plots (N-5, N-4, N-3, N-2, and N-1st points in order from the surface side) positioned on the surface side of the inorganic thin film layer with respect to the point N and five plots (N+1, N+2, N+3, N+4, N+5th points in order from the surface side) positioned on the base material layer side with respect to the point N are extracted. In a case in which these consecutive N-5th to N+5th points satisfy the following (4), any of (5-1) to (5-3), and any of (6-1) to (6-3), the point N may be judged to be the minimum value.
(4) The value at the point N is smaller than the value at any of N-5 to N-1 and N+1 to N+5.
(5) When the increase or decrease in value at the plot when the plot number increases by 1 is evaluated for the N-5 to N-1st plots,
(5-1) The value decreases monotonically from N-5 to N-1 (there are four plots of which the value decreases when the plot number increases by 1),
(5-2) When the plot number increases by 1, there are three plots of which the value decreases, there is one plot of which the value does not change or increases, and the amount of increase in value is 80% or less of the difference between the value at the point N and the greatest value among the values at the plots N-5 to N-1 in a case in which the value increases, or
(5-3) When the plot number increases by 1, there are two plots of which the value decreases, there is two plots of which the value does not change or increases, and the amount of increase in value is 60% or less of the difference between the value at the point N and the greatest value among the values at the plots N-5 to N-1 in a case in which the value increases.
(6) When the increase or decrease in value at the plot when the plot number increases by 1 is evaluated for the N+1 to N+5th plots,
(6-1) The value increases monotonically from N+1 to N+5 (there are four plots of which the value increases when the plot number increases by 1),
(6-2) When the plot number increases by 1, there are three plots of which the value increases, there is one plot of which the value does not change or decreases, and the amount of decrease in value is 80% or less of the difference between the value at the point N and the greatest value among the values at the plots N+1 to N+5 in a case in which the value decreases, or
(6-3) When the plot number increases by 1, there are two plots of which the value increases, there is two plots of which the value does not change or decreases, and the amount of decrease in value is 60% or less of the difference between the value at the point N and the greatest value among the values at the plots N+1 to N+5 in a case in which the value decreases.

In (2-2), (3-2), (5-2), and (6-2) above, the difference may be 80% or less but is preferably 50% or less, more preferably 30% or less. In (2-3), (3-3), (5-3), and (6-3) above, the difference may be 60% or less but is preferably 30% or less, more preferably 10% or less. When the difference is in the above range, it can be judged that there is regularity in the increase or decrease with the point M or N as the inflection point in the plotted zone centered on the reference point M or N.

A method for designating a region BD in a depth profile measured from the surface of the laminated body according to an embodiment of the present invention on the inorganic thin film layer side in the thickness direction using TOF-SIMS will be described. The region BD is a region designated by determining a depth B and a depth D, where

(1) an average ionic strength in a region A1 in which an absolute value of a coefficient of variation of an ionic strength value on a base material layer side is within 5% is denoted as $I_{CA1}$, a depth that is closest to the region A1 on a surface side of the inorganic thin film layer with respect to the region A1 and exhibits an ionic strength to be 0.5 times or less the $I_{CA1}$ is denoted as A2, and a depth that is closest to A2 on a surface side of the inorganic thin film layer with respect to A2 and exhibits a minimum value is denoted as A3 in an ionic strength curve of C⁻, and

(2) a depth that is closest to A3 on a surface side of the inorganic thin film layer with respect to A3 and has a differential value of 0 or more is denoted as B, a depth that is closest to A3 on a base material layer side with respect to A3 and exhibits a maximum value $d(I_C)_{max}$ of differential distribution value is denoted as C, and a depth that is closest to C on a base material layer side with respect to C and has an absolute value of differential value to be 0.01 times or less the $d(I_C)_{max}$ is denoted as D in a first-order differential curve of ionic strength of C⁻.

When the ionic strengths of Si⁻, C⁻, and $O_2^-$ are measured from the surface of the laminated body on the inorganic thin film layer side in the thickness direction using TOF-SIMS, an ionic strength curve taking the ionic strength as the vertical axis and the number of sputterings as the horizontal axis is acquired. The number of sputterings on the horizontal axis can be converted into a distance (depth) from the surface on the inorganic thin film layer side by a method described later. With regard to (1) above, the region A1 and the depths A2 and A3 are determined using the ionic strength curve of C⁻. First, the average ionic strength in the region A1 in which the absolute value of the coefficient of variation of the ionic strength value on the base material layer side is within 5% is denoted as $I_{CA1}$. The region A1 is a region in which the absolute value of the coefficient of variation of the ionic strength value on the base material layer side is within 5% and is thus a region having a homogeneous composition in which variations in the strength of ions contained in the base material layer are suppressed. Here, in an embodiment of the present invention, the laminated body has a base material layer containing at least a flexible base material, and the flexible base material usually has a homogeneous composition. Hence, when the depth profile is measured from the surface of the laminated body on the inorganic thin film layer side in the thickness direction, the variation in ionic strength is suppressed and the value is almost constant in the region corresponding to the flexible base material. The average ionic strength at this portion may be taken as $I_{CA1}$. As the method for calculating the average ionic strength $I_{CA1}$ of the region A1, first, the ionic strengths at least at five points are read in a predetermined region in which the ionic strength value is almost unchanged in the ionic strength curve of C⁻. The average value and standard deviation of the read ionic strengths are calculated. The coefficient of variation is acquired by dividing the standard deviation by the average value. In a case in which the coefficient of variation calculated in this way is within 5%, the predetermined region is defined as the region A1 and the average value of the ionic strengths acquired as described above is defined as the average ionic strength $I_{CA1}$. The size (distance) of the region A1 is not particularly limited but is preferably 1 to 50 nm, more preferably 3 to 20 nm when the number of sputterings is converted into a distance by the method described later from the viewpoint of being easy to confirm that there is no variation in ionic strength within the measured section.

The depth that is closest to the region A1 on the surface side of the inorganic thin film layer with respect to the region A1 determined as described above and exhibits an ionic strength to be 0.5 times or less the $I_{CA1}$ (average ionic strength in the region A1) is denoted as A2, and the depth that is closest to A2 on the surface side of the inorganic thin film layer with respect to A2 and exhibits a minimum value is denoted as A3.

Next, with regard to (2) above, the depths B, C, and D are determined using the first-order differential curve of the ionic strength of C⁻, and the region BD is determined. First, the depth A3 determined in (1) is taken as the reference, and the depth that is closest to A3 on the surface side of the inorganic thin film layer with respect to A3 and has a differential value of 0 or more is denoted as B, the depth that is closest to A3 on the base material layer side with respect to A3 and exhibits the maximum value $d(I_C)_{max}$ of differential distribution value is denoted as C, and the depth that is closest to C on the base material layer side with respect to C and has an absolute value of differential value to be 0.01 times or less the $d(I_C)_{max}$ is denoted as D. The region BD is designated by determining the depth B and the depth D in this way. Here, since Ic gradually approaches $I_{CA1}$ on the base material layer side with respect to the depth D, the depth D is considered to be a depth corresponding to the position of the interface between the inorganic thin film layer and the base material layer of the laminated body. Hence, the distance from the outermost surface of the inorganic thin film layer to the depth D corresponds to the film thickness of the inorganic thin film layer. Here, in the ionic strength curve measured using TOF-SIMS takes the ionic strength as the vertical axis and the number of sputterings as the horizontal axis as described above. The number of sputterings relatively corresponds to the depth in the thickness direction. Hence, assuming that the film thickness of the inorganic thin film layer corresponds to the number of sputterings from the outermost surface of the inorganic thin film layer to the depth D, the number of sputterings can be converted into the distance (depth) from the outermost surface of the inorganic thin film layer by using the relation of these. Specifically, the number of sputterings can be converted into the depth by multiplying the value obtained by dividing the film thickness of the inorganic thin film layer by the number of sputterings from the outermost surface of the inorganic thin film layer to the depth D by the number of sputterings to be converted. Therefore, in the present specification, regarding the description of the ionic strength curve, there is a case in which the number of sputterings is replaced with the depth due to the relation. The film thickness of the inorganic thin film layer is, for example, an average value measured at least at two points using a fine shape measuring machine (Surfcorder ET3000 manufactured by Kosaka Laboratory Ltd.) for the ones described in Examples. The details of the measurement method are as described in Examples.

In an embodiment of the present invention, in the laminated body, the distribution curve of $I_{O2}/I_{Si}$ has at least one maximum value $(I_{O2}/I_{Si})_{maxBD}$ in the region BD determined by the above method. In a case in which the region BD does not have a maximum value $(I_{O2}/I_{Si})_{maxBD}$, sufficient adhesive property between the inorganic thin film layer and the base material layer cannot be obtained particularly after the bending resistance test. The maximum value $(I_{O2}/I_{Si})_{maxBD}$ is preferably 0.4 or more, more preferably 0.5 or more, still more preferably 0.6 or more, particularly preferably 0.7 or more from the viewpoint of easily obtaining the stress relaxation function at the interface between the inorganic thin film layer and the base material and of easily enhancing the adhesive property. The upper limit of the maximum value $(I_{O2}/I_{Si})_{maxBD}$ is not particularly limited but is usually 1 or less, preferably 0.9 or less.

The method for obtaining a laminated body having the above features in the depth profile is not particularly limited, but examples thereof include (1) a method in which a magnetic field forming apparatus (magnet for magnetic field formation) is additionally disposed in the deposition rolls and a deposition region for obtaining a region in which the amount of $O_2^-$ is larger than that of $Si^-$ and the above depth profile is acquired is provided, (2) a method in which the intensity distribution of plasma generated between rolls is adjusted by adjusting the diameter of the deposition rolls and a deposition region for obtaining the above region is provided, (3) a method in which the ratio of the flow rate of source gas and the flow rate of reactant gas to the electric power is adjusted, (4) a method in which the above region is formed by the reaction of a trace amount of outgas such as moisture from the base material with a source gas and a reactant gas, and (5) a method in which a component having a high abundance of $SiO_x$ is preferentially laminated on the base material surface by the interaction between the substance on the base material surface and the source gas and the reactant gas, for example, in the case of laminating the inorganic thin film layers by plasma enhanced CVD in which discharge plasma is generated between the deposition rolls and thus the inorganic thin film layer is formed. For example, in the method (1), for example, a method is mentioned in which the first magnetic field forming apparatuses are disposed in the respective deposition rolls so as to be substantially opposed to each other between the two deposition rolls and an additional magnetic field forming apparatus is disposed at a different position in the deposition roll separated from the gas supply pipe farther than the magnetic field forming apparatus so as to face the outside instead of the rotation axis side of the deposition roll. As the gas composition in the vicinity of the additional magnetic field forming apparatus, the ratio of oxygen is large, for example, in a case in which HMDSO is used as the source gas and oxygen is used as the reactant gas since the source gas has been consumed between the deposition rolls. In addition to this, a trace amount of outgas emitted from the base material also acts as a source gas, and thus the inorganic thin film layer laminated at the initial stage has a higher abundance of $SiO_x$ than the inorganic thin film layer laminated thereafter in a case in which the outgas is those containing oxygen atoms such as moisture. Due to the composite factor of these, the amount of $O_2^-$ with respect to that of $Si^-$ acquired by TOF-SIMS measurement can be increased in the region adjacent to the interface between the inorganic thin film layer and the base material. Not only any one of the methods is used but also a plurality of the methods may be used in combination.

In the depth profile measured from the surface of the laminated body according to an embodiment of the present invention on the inorganic thin film layer side in the thickness direction using TOF-SIMS, the depth from the outermost surface on the inorganic thin film layer side to 5 nm on the base material layer side is denoted as E and the region between the depth E and the depth B is defined as the region EB. In a preferred embodiment of the present invention, the standard deviation of $I_{O2}/I_{Si}$ is preferably 0.07 or less, more preferably 0.06 or less, still more preferably 0.05 or less, particularly preferably 0.04 or less in the above-determined region EB of the laminated body. As described above, the region BD is a part of the region included in the inorganic thin film layer in which the amount of $O_2^-$ is larger than that of $Si^-$ and is a region adjacent to the interface between the inorganic thin film layer and the base material layer. Since the amount of $O_2^-$ is larger than that of $Si^-$ from the depth B, the depth B is a depth that enters the region. Hence, the region EB between the depth E and the depth B is a region of the portion of the inorganic thin film layer excluding the region from the outermost surface on the inorganic thin film layer side to 5 nm in the thickness direction and the region adjacent to the interface between the inorganic thin film layer and the base material layer as described above. The fact that the standard deviation of $I_{O2}/I_{Si}$ is within the above range in this region indicates that the inorganic thin film layer is homogeneous in the region EB. Hence, in a case in which the standard deviation of $I_{O2}/I_{Si}$ is less than or equal to the upper limit, it can be said that the gas barrier property is easily enhanced since the inorganic thin film layer is homogeneous, is highly dense, and has few defects such as fine voids and cracks. The portion from the outermost surface on the inorganic thin film layer side to 5 nm is a portion into which ions are easily mixed by the reaction with the adhesive residue of the protective film on the laminated body and impurities in the atmospheric air or which is easily affected by the external atmosphere. Hence, in the laminated body according to an embodiment of the present invention except the portion from the outermost surface on the inorganic thin film layer side to 5 nm and the region adjacent to the interface, it is preferable that the standard deviation of $I_{O2}/I_{Si}$ is within the above range. The lower limit of the standard deviation of $I_{O2}/I_{Si}$ is not particularly limited and may be 0 or more. The standard deviation $\sigma_{O2EB}$ of $I_{O2}/I_{Si}$ can be calculated by Equation (1), where the number of sputterings in the region EB is denoted as n, the measured value at each plot is denoted as $X_{EB}$, and the average value of all plots is denoted as $\mu_{EB}$.

[Math. 1]

$$\sigma_{O2EB} = \sqrt{\frac{1}{n}\sum_{i=1}^{n}\left(x_{EBi} - \mu_{EB}\right)^2} \qquad (1)$$

The methods for designating the region BD and the region EB will be described in more detail with reference to the drawings in Examples of the present specification.

In the laminated body according to an embodiment of the present invention, the distribution curve of Ic/Isi preferably has at least one minimum value $(I_C/I_{Si})_{minBD}$ in the region BD determined by the above method. The minimum value $(I_C/I_{Si})_{minBD}$ is preferably 0.8 or less, more preferably 0.7 or less, still more preferably 0.6 or less, particularly preferably 0.5 or less from the viewpoint of increasing the ratios of Si⁻ and $O_2^-$ in the region and easily obtaining the stress relaxation function at the interface between the inorganic thin film layer and the base material. The lower limit of the minimum value $(I_C/I_{Si})_{minBD}$ is not particularly limited but is usually 0.05 or more, preferably 0.1 or more.

In a preferred embodiment of the present invention, the standard deviation of $I_C/I_{Si}$ is preferably 0.15 or less, more preferably 0.1 or less, still more preferably 0.07 or less, particularly preferably 0.05 or less in the above-determined region EB of the laminated body. Similarly to the description of $I_{O2}/I_{Si}$ in the region EB, the fact that the standard deviation of $I_C/I_{Si}$ is within the above range in this region indicates that the inorganic thin film layer is homogeneous in the region EB. Hence, in a case in which the standard deviation of Ic/Isi is less than or equal to the upper limit, it can be said that the gas barrier property is easily enhanced since the inorganic thin film layer is homogeneous, is highly dense, and has few defects such as fine voids and cracks. The lower limit of the standard deviation of $I_C/I_{Si}$ is not particularly limited and may be 0 or more. The standard deviation $\sigma_{CEB}$ of Ic/Isi can be calculated by Equation (2), where the number of sputterings in the region EB is denoted as n, the measured value at each plot is denoted as $y_{EB}$, and the average value of all plots is denoted as $\mu_{EB}$.

[Math. 2]

$$\sigma_{CEB} = \sqrt{\frac{1}{n}\sum_{i=1}^{n}\left(y_{EBi} - \mu_{EB}\right)^2} \qquad (2)$$

The method for reducing the standard deviations of $I_C/I_{Si}$ and $I_{O2}/I_{Si}$ in the above region is not particularly limited, but the standard deviations can be reduced by stabilizing the intensity distribution of plasma, for example, in the case of laminating the inorganic thin film layer by plasma enhanced CVD in which discharge plasma is generated between the deposition rolls and thus the inorganic thin film layer is formed. Examples of the method for stabilizing the intensity distribution of plasma include a method in which a deposition roll having a larger diameter is used and a method in which the transport velocity is increased. In the case of using a deposition roll having a larger diameter, the distances between start and center and end of the deposition region between the deposition rolls approach constant values and thus the intensity distribution of plasma generated in the deposition region is stabilized. In the case of increasing the transport velocity, since the transit times at the location where the plasma intensity is high and the location where the plasma intensity is low in one pass are shortened, the influence of the difference in the intensity distribution of plasma decreases and the variation in the composition distribution of the inorganic thin film layer in the depth direction decreases. From the viewpoint of reducing the standard deviation of Ic/Isi and $I_{O2}/I_{Si}$ in the above region and easily enhancing the gas barrier property and from the viewpoint of easily reducing the thermal damage to the base material during deposition of the inorganic thin film layer, the transport velocity of the base material when laminating the inorganic thin film layer is preferably 0.1 to 100 m/min, more preferably 1 to 20 m/min, still more preferably 3 to 15 m/min. From the viewpoint of stabilizing the plasma intensity distribution in the deposition region, the diameter of the deposition roll is preferably 5 cm or more and 100 cm or less, more preferably 15 cm or more and 50 cm or less.

With regard to the laminated body according to an embodiment of the present invention, the distance (hereinafter, also referred to as "distance X") between the depth exhibiting the maximum value $(I_{O2}/I_{Si})_{maxBD}$ and the depth exhibiting the minimum value $(I_C/I_{Si})_{minBD}$ is preferably 0.7 times or less the distance of the region BD (distance between the depth B and the depth D). The fact that the distance X is 0.7 times or less the distance of the region BD indicates that the location where the amount of $O_2^-$ is larger than that of $Si^-$ corresponds exactly to one of the extreme values formed by the composition in the inorganic thin film layer in the region BD. Hence, in a case in which the distance X is less than or equal to the upper limit, the stress relaxation function of the region BD is easily exerted. From a similar viewpoint, the distance X is preferably 0.7 times or less, more preferably 0.5 times or less, still more preferably 0.3 times or less the distance of the region BD. The distance of the region BD is preferably 1 to 300 nm, more preferably 3 to 100 nm, still more preferably 5 to 50 nm. When the distance of the region is in the above range, the effect of improving the adhesive property after the bending test becomes apparent and cracking is less likely to occur at the time of the bending test.

Next, in an embodiment of the present invention, a method for setting the region GH in the depth profile measured from the surface of the laminated body on the inorganic thin film layer side in the thickness direction using TOF-SIMS will be described. In an embodiment of the present invention in which the region GH is set, the laminated body has at least a base material layer containing at least a flexible base material and a layer containing a component having a urethane bond and an inorganic thin film layer. Here, examples of the component having a urethane bond include urethane acrylate, urethane (meth)acrylate, urethane diacrylate, and urethane di(meth)acrylate. Examples of the layer containing a component having a urethane bond include an undercoat layer, a primer layer, and an anti-blocking layer.

The region GH is a region designated by determining the depth G and the depth H, where (3) a depth that exhibits a maximum value $d(I_{CN})_{max}$ of differential distribution value is denoted as F, a depth that is closest to F on a surface side of the inorganic thin film layer with respect to F and has an absolute value of differential value to be 0.01 times or less the maximum value $d(I_{CN})_{max}$ is denoted as G, and a depth that is closest to F on a base material layer side with respect to F and has an absolute value of differential value to be 0.01 times or less the maximum value $d(I_{CN})_{max}$ is denoted as H in a first-order differential curve of ionic strength of $CN^-$.

When the ionic strengths of $CN^-$, $Si^-$, $C^-$, and $O_2^-$ are measured from the surface of the laminated body on the inorganic thin film layer side in the thickness direction using TOF-SIMS, an ionic strength curve taking the ionic strength as the vertical axis and the number of sputterings as the horizontal axis is acquired. With regard to (3) above, the depths F, G, and H are determined using the first-order differential curve of the ionic strength of $CN^-$. First, the depth that exhibits the maximum value $d(I_{CN})_{max}$ of the differential distribution value is denoted as F and the depth that is closest to F on the base material layer side with respect to F and has an absolute value of differential value to be 0.01 times or less the maximum value $d(I_{CN})_{max}$ is denoted as G. Here, the $CN^-$ ion is an ion that is observed by being derived from the urethane bond in an embodiment of the present invention in which the base material layer contains a layer containing a component having a urethane bond. Hence, the peak of the differential distribution value in the first-order differential curve of the ionic strength of $CN^-$ represents an inflection point where the slope of the tangent changes when the ionic strength of $CN^-$ increases, and the fact that the peak falls and becomes constant indicates that the region has reached a region in which the ionic strength of $CN^-$ does not change (in other words, a layer containing a component having a urethane bond). The layer containing a component having a urethane bond is often, for example, an undercoat layer, a primer layer, an anti-blocking layer or the like applied between a flexible base material and an inorganic thin film layer. In this case, the measurement proceeds from the surface of the laminated body on the inorganic thin film layer side in the thickness direction, and the depth H at which the increase in ionic strength of $CN^-$ derived from the urethane bond is stabilized can be said to be the depth that reaches the layer which contains a component having a urethane bond and in which the ionic strength of $CN^-$ does not change. Hence, the depth H is considered to be a depth corresponding to the interface between the inorganic thin film layer and the base material layer of the laminated body. Hence, the distance from the outermost surface of the inorganic thin film layer to the depth H corresponds to the film thickness of the inorganic thin film layer. Therefore, similarly to the description regarding the distance to the depth D, the number of sputterings may be converted into the distance (depth) from the outermost surface of the inorganic thin film layer by using the relation between the film thickness of the inorganic thin film layer and the number of sputterings from the outermost surface of the inorganic thin film layer to the depth H. Specifically, the number of sputterings may be converted into the depth by multiplying the value obtained by dividing the film thickness of the inorganic thin film layer by the number of sputterings from the outermost surface of the inorganic thin film layer to the depth H by the number of sputterings to be converted.

The method for measuring the film thickness of the inorganic thin film layer is as described above.

In an embodiment of the present invention, in the laminated body, the distribution curve of $I_{O2}/I_{Si}$ has at least one maximum value $(I_{O2}/I_{Si})_{maxGH}$ in the region GH determined by the above method. The maximum value $(I_{O2}/I_{Si})_{maxGH}$ is preferably 0.4 or more, more preferably 0.5 or more, still more preferably 0.6 or more, particularly preferably 0.7 or more from the viewpoint of more reliably obtaining the stress relaxation function at the interface between the inorganic thin film layer and the base material, and the upper limit of the maximum value $(I_{O2}/I_{Si})_{maxGH}$ is not particularly limited but is usually 1 or less, preferably 0.9 or less.

With regard to the depth profile measured from the surface of the laminated body according to an embodiment of the present invention on the inorganic thin film layer side in the thickness direction using TOF-SIMS, the depth from the outermost surface on the inorganic thin film layer side to 5 nm on the base material layer side is denoted as E and the depth separated from the depth G toward the surface side of the inorganic thin film layer at a distance equal to the distance between the depth G and the depth H is denoted as J. Here, the depth H is a depth at which the ionic strength of $CN^-$ does not change as described above and is thus understood to be the depth that reaches the layer containing a component having a urethane bond, and it is considered that the region between the depth G and the depth H (the region adjacent to the interface between the inorganic thin film layer and the base material layer) is affected by the component having a urethane bond such as an undercoat layer to some extent in some cases. The depth J is the depth determined as described above in the inorganic thin film layer from the viewpoint of designating the region of the inorganic thin film layer in which the influence of the flexible base material and the component having a urethane bond which are contained in the base material layer is not sufficiently observed. In a preferred embodiment of the present invention, the standard deviation of $I_{O2}/I_{Si}$ is preferably 0.07 or less, more preferably 0.06 or less, still more preferably 0.05 or less, particularly preferably 0.04 or less in the above-determined region EJ of the laminated body. The region EJ is a region corresponding to the region EB. Similarly to the region EB, the region EJ between the depth E and the depth J is a region of the portion of the inorganic thin film layer excluding 5 nm from the outermost surface on the inorganic thin film layer side and the region JH adjacent to the interface between the inorganic thin film layer and the base material layer as described above. The fact that the standard deviation of $I_{O2}/I_{Si}$ is within the above range in this region indicates that the inorganic thin film layer is homogeneous in the region EJ, and in a case in which the standard deviation of $I_{O2}/I_{Si}$ is less than or equal to the upper limit, the gas barrier property is easily enhanced since the inorganic thin film layer is homogeneous, is highly dense, and has few defects such as fine voids and cracks. The lower limit of the standard deviation of $I_{O2}/I_{Si}$ is not particularly limited and may be 0 or more. The standard deviation $\sigma_{O2EJ}$ of $I_{O2}/I_{Si}$ can be calculated by Equation (3), where the number of sputterings in the region EJ is denoted as n, the measured value at each plot is denoted as $X_{EJ}$, and the average value of all plots is denoted as $\mu_{EJ}$.

[Math. 3]

$$\sigma_{O2EJ} = \sqrt{\frac{1}{n}\sum_{i=1}^{n}\left(x_{EJi} - \mu_{EJ}\right)^2} \qquad (3)$$

The methods for designating the region GH and the region EJ will be described in more detail with reference to the drawings in Examples of the present specification.

In the laminated body according to an embodiment of the present invention, the distribution curve of Ic/Isi preferably has at least one minimum value $(I_C/I_{Si})_{minGH}$ in the region GH determined by the above method. The minimum value $(I_C/I_{Si})_{minGH}$ is preferably 0.8 or less, more preferably 0.7 or less, still more preferably 0.6 or less, particularly preferably 0.5 or less from the viewpoint of increasing the ratios of $Si^-$ and $O_2^-$ in the region and easily obtaining the stress relaxation function at the interface between the inorganic thin film layer and the base material. The lower limit of the minimum value $(I_C/I_{Si})_{minGH}$ is not particularly limited but is usually 0.05 or more, preferably 0.1 or more.

In a preferred embodiment of the present invention, the standard deviation of $I_C/I_{Si}$ is preferably 0.15 or less, more preferably 0.1 or less, still more preferably 0.07 or less, particularly preferably 0.05 or less in the above-determined region EJ of the laminated body. Similarly to the description of $I_{O2}/I_{Si}$ in the region EJ, the fact that the standard deviation of $I_C/I_{Si}$ is within the above range in this region indicates that the inorganic thin film layer is homogeneous in the region EJ. Hence, in a case in which the standard deviation of Ic/Isi is less than or equal to the upper limit, the gas barrier property is easily enhanced since the inorganic thin film layer is homogeneous, is highly dense, and has few defects such as fine voids and cracks. The lower limit of the standard deviation of $I_C/I_{Si}$ is not particularly limited and may be 0 or more. The standard deviation $\sigma_{CEJ}$ of $I_C/I_{Si}$ can be calculated by Equation (4), where the number of sputterings in the region EJ is denoted as n, the measured value at each plot is denoted as $y_{EJ}$, and the average value of all plots is denoted as $\mu_{EJ}$.

[Math. 4]

$$\sigma_{CEJ} = \sqrt{\frac{1}{n}\sum_{i=1}^{n}\left(y_{EJi} - \mu_{EJ}\right)^2} \qquad (4)$$

With regard to the laminated body according to an embodiment of the present invention, the distance (hereinafter, also referred to as "distance Y") between the depth exhibiting the maximum value $(I_{O2}/I_{Si})_{maxGH}$ and the depth exhibiting the minimum value $(I_C/I_{Si})_{minGH}$ is preferably 0.7 times or less the distance of the region GH (distance between the depth G and the depth H). The fact that the distance Y is 0.7 times or less the distance of the region GH indicates that the location where the amount of $O_2^-$ is larger than that of $Si^-$ corresponds exactly to one of the extreme values formed by the composition in the inorganic thin film layer in the region GH. Hence, in a case in which the distance Y is less than or equal to the upper limit, the stress relaxation function of the region BD is easily exerted. From a similar viewpoint, the distance Y is preferably 0.7 times or less, more preferably 0.5 times or less, still more preferably 0.3 times or less the distance of the region GH. The distance of the region GH is preferably 1 to 300 nm, more preferably 3 to 100 nm, still more preferably 5 to 50 nm. When the distance of the region GH is in the above range, the effect of improving the adhesive property after the bending test becomes apparent and cracking is less likely to occur at the time of the bending test.

In the depth profile measured from the surface of the laminated body according to an embodiment of the present invention on the inorganic thin film layer side in the thickness direction using TOF-SIMS, the ionic strength curve of $C^-$ has extreme values and the number of extreme values is preferably at least 3, more preferably 3 to 40, still more preferably 10 to 35, particularly preferably 20 to 30, most preferably 25 to 30. The ionic strength curve of $C^-$ has maximum values, and the number of maximum values is preferably 3 to 20, more preferably 10 to 15. The ionic strength curve of $C^-$ has minimum values, and the number of minimum values is preferably 3 to 20, more preferably 10 to 15. When the numbers of extreme values, maximum values, and/or minimum values are in the above ranges, the gas barrier property of the laminated body is likely to be favorable. The depth having an extreme value on the ionic strength curve of $C^-$ corresponds to the depth at which the differential value becomes 0 on the first-order differential curve of the ionic strength of $C^-$.

The total light transmittance (Tt) through the laminated body according to an embodiment of the present invention is preferably 88.0% or more, more preferably 88.5% or more, still more preferably 89.0% or more, particularly preferably 89.5% or more, extremely preferably 90.0% or more. When the total light transmittance is in the above range, it is easy to secure sufficient visibility when the laminated body is incorporated into a flexible electronic device such as an image display device. The upper limit value of the total light transmittance through the laminated body is not particularly limited and may be 100% or less. The total light transmittance can be measured by the method described in Examples. It is preferable that the laminated body after being exposed to an environment at 60°C and a relative humidity of 90% for 250 hours still has a total light transmittance in the above range.

In an embodiment of the present invention, the haze (cloud value) of the laminated body is preferably 1.0% or less, more preferably 0.8% or less, still more preferably 0.5% or less. When the haze is in the above range, it is easy to secure sufficient visibility when the laminated body is incorporated into a flexible electronic device such as an image display device. The lower limit value of the haze of the laminated body is not particularly limited and may be 0% or more. The haze of the laminated body can be measured by using the same apparatus as that used for the measurement of total light transmittance. It is preferable that the laminated film after being exposed to an environment at 60°C and a relative humidity of 90% for 250 hours still has a haze in the above range.

In an embodiment of the present invention, the yellowness YI of the laminated body measured in conformity with JIS K 7373: 2006 is preferably 5 or less, more preferably 3 or less, still more preferably 2.5 or less, particularly preferably 2.0 or less. When the yellowness YI is less than or equal to the upper limit, it is easy to secure sufficient visibility when the laminated body is incorporated into a flexible electronic device such as an image display device. The yellowness YI can be measured in conformity with JIS K 7373: 2006 using a spectrophotometer (for example, ultraviolet-visible near-infrared spectrophotometer V-670 manufactured by JASCO Corporation). Specifically, background measurement is performed in a state in which the sample is not set, then the sample is set in the sample holder, the transmittance of light at 300 to 800 nm is measured, tristimulus values (X, Y, Z) are determined, and the yellowness YI is calculated from these values based on Equation (5).

[Math. 5]

$$YI = 100 \times (1.2769X - 1.0592Z) / Y \qquad (5)$$

In an embodiment of the present invention, the thickness of the laminated body can be appropriately adjusted depending on the application but is preferably 5 to 200 μm, more preferably 10 to 150 μm, still more preferably 20 to

130 $\mu$m. The thickness of the laminated body can be measured using a film thickness meter. When the thickness of the laminated body is equal to or more than the lower limit, it is easy to enhance the handleability as a film, the surface hardness, and the like. When the thickness is less than or equal to the upper limit, the bending resistance of the laminated body is easily enhanced.

In an embodiment of the present invention, the laminated body is a laminated body having at least a base material layer containing at least a flexible base material and an inorganic thin film layer and is preferably a laminated film.

(Inorganic thin film layer)

In an embodiment of the present invention, the laminated body has at least a base material layer and an inorganic thin film layer. The laminated body may have one inorganic thin film layer or two or more inorganic thin film layers. The inorganic thin film layer may be a single-layer film or a multilayer film in which two or more layers including at least the single-layer film are laminated.

The thickness of the inorganic thin film layer may be appropriately adjusted depending on the application but is preferably 0.1 to 2 $\mu$m, more preferably 0.2 to 1.5 $\mu$m, still more preferably 0.3 to 1 $\mu$m. The thickness of the inorganic thin film layer can be measured using a film thickness meter or a step gauge. When the thickness is equal to or more than the lower limit, the gas barrier property is easily improved. When the thickness is less than or equal to the upper limit, the bending property is easily improved. In an embodiment of the present invention, in a case in which the laminated body has two or more inorganic thin film layers, the thicknesses of the respective inorganic thin film layers may be the same as or different from one another. In a case in which the laminated body has two or more inorganic thin film layers, it is preferable that each inorganic thin film layer has the thickness. The thickness of the inorganic thin film layer is measured using a step gauge, for example, as presented in Examples.

The inorganic thin film layer contains at least a silicon atom (Si), an oxygen atom (O), and a carbon atom (C). A laminated body having an inorganic thin film layer containing these atoms has excellent gas barrier property (particularly water vapor permeation preventing property). A laminated body having the inorganic thin film layer is excellent from the viewpoint of bending resistance, ease of manufacture, and low manufacturing cost as well.

The inorganic thin film layer may contain a compound represented by a general formula of $SiO_{\alpha}C_{\beta}$ [where $\alpha$ and $\beta$ each independently denote a positive number less than 2] as the main component. Here, "to contain as the main component" means that the content of the component is 50% by mass or more, preferably 70% by mass or more, more preferably 90% by mass or more with respect to the mass of all components of the material. The inorganic thin film layer may contain one compound represented by the general formula $SiO_{\alpha}C_{\beta}$ or two or more compounds represented by the general formula $SiO_{\alpha}C_{\beta}$. $\alpha$ and/or $\beta$ in the general formula may be constant values or vary in the film thickness direction of the inorganic thin film layer.

The inorganic thin film layer may contain elements other than the silicon atom, oxygen atom, and carbon atom, for example, one or more atoms among a hydrogen atom, a nitrogen atom, a boron atom, an aluminum atom, a phosphorus atom, a sulfur atom, a fluorine atom, and a chlorine atom.

In a case in which the surface of the inorganic thin film layer is subjected to infrared spectroscopic (ATR method) measurement, it is preferable that the intensity ratio ($I_2/I_1$) of the peak intensity ($I_1$) present at 950 to 1,050 cm$^{-1}$ to the peak intensity (I2) present at 1,240 to 1,290 cm$^{-1}$ satisfies Equation (6).

[Math. 6]

$$0.01 \leqq I_2 / I_1 < 0.05 \qquad (6)$$

The peak intensity ratio $I_2/I_1$ calculated from the results of infrared spectroscopic (ATR method) measurement is considered to indicate the relative proportion of Si-CH$_3$ to Si-O-Si in the inorganic thin film layer. The inorganic thin film layer satisfying the relation represented by Equation (6) is highly dense, defects such as fine voids and cracks are easily decreased, and it is thus considered that the gas barrier property and impact resistance are easily enhanced. The peak intensity ratio $I_2/I_1$ is preferably $0.02 \leq I_2/I_1 < 0.04$ from the viewpoint of being easy to maintain high denseness of the inorganic thin film layer.

In a case in which the inorganic thin film layer satisfies the range of the peak intensity ratio $I_2/I_1$, the laminated film is likely to be properly slippery and blocking is easily diminished. The fact that the peak intensity ratio $I_2/I_1$ is too large means that the number of Si-C is too large. In this case, the bending property tends to be poor and slippage tends to hardly occur. When the peak intensity ratio $I_2/I_1$ is too small, the bending property tends to decrease by a too small number of Si-C.

The infrared spectroscopic measurement of the surface of the inorganic thin film layer can be performed using a Fourier transform type infrared spectrophotometer (FT/IR-460Plus manufactured by JASCO Corporation) equipped with an ATR attachment (PIKE MIRacle) using germanium crystal as prism.

In a case in which the surface of the inorganic thin film layer is subjected to infrared spectroscopic (ATR method) measurement, it is preferable that the intensity ratio ($I_3/I_1$) of the peak intensity ($I_1$) present at 950 to 1,050 cm$^{-1}$ to the peak intensity ($I_3$) present at 770 to 830 cm$^{-1}$ satisfies Equation (7).
[Math. 7]

$$0.25 \leqq I_3 / I_1 \leqq 0.50 \qquad (7)$$

The peak intensity ratio $I_3/I_1$ calculated from the results of spectroscopic (ATR method) measurement is considered to indicate the relative proportion of Si-C, Si-O and the like to Si-O-Si in the inorganic thin film layer. With regard to the inorganic thin film layer which satisfies the relation represented by Equation (7), it is considered that the bending resistance is easily enhanced since carbon is introduced into the layer and the impact resistance is also easily enhanced while high denseness is maintained. The peak intensity ratio $I_3/I_1$ is preferably in a range of $0.25 \leq I_3/I_1 \leq 0.50$, more preferably in a range of $0.30 \leq I_3/I_1 \leq 0.45$ from the viewpoint of maintaining the balance between the denseness and bending resistance of the inorganic thin film layer.

In a case in which the thin film layer surface is subjected to infrared spectroscopic (ATR method) measurement, it is preferable in the thin film layer that the intensity ratio of the peak intensity ($I_3$) present at 770 to 830 cm$^{-1}$ to the peak intensity ($I_4$) present at 870 to 910 cm$^{-1}$ satisfies Equation (8).
[Math. 8]

$$0.70 \leqq I_4 / I_3 < 1.00 \qquad (8)$$

The peak intensity ratio $I_4/I_3$ calculated from the results of infrared spectroscopic (ATR method) measurement is considered to represent the ratio between peaks related to Si-C in the inorganic thin film layer. With regard to the inorganic thin film layer which satisfies the relation represented by Equation (8), it is considered that the bending resistance is easily enhanced since carbon is introduced into the layer and the impact resistance is also easily enhanced while high denseness is maintained. With regard to the range of the peak intensity ratio $I_4/I_3$, a range of $0.70 \leq I_4/I_3 < 1.00$ is preferable and a range of $0.80 \leq I_4/I_3 < 0.95$ is more preferable from the viewpoint of maintaining the balance between the denseness and bending resistance of the inorganic thin film layer.

The inorganic thin film layer may preferably have a high average density of 1.8 g/cm$^3$ or more. Here, the "average density" of the inorganic thin film layer is determined by calculating the weight of the thin film layer in the measurement range from the number of silicon atoms, the number of carbon atoms, and the number of oxygen atoms determined by Rutherford Backscattering Spectrometry (RBS) and the number of hydrogen atoms determined by Hydrogen Forward Scattering Spectrometry (HFS) and dividing the weight by the volume (the product of the area irradiated with the ion beam and the film thickness) of the thin film layer in the measurement range. It is preferable that the average density of the inorganic thin film layer is equal to or more than the lower limit since the inorganic thin film layer has a structure which has high denseness and in which defects such as fine voids and cracks are easily decreased. In a preferred embodiment of the present invention in which the inorganic thin film layer contains a silicon atom, an oxygen atom, a carbon atom, and a hydrogen atom, the average density of the inorganic thin film layer is preferably less than 2.22 g/cm$^3$.

The inorganic thin film layer formed so as to satisfy the conditions can exert gas barrier property required for a flexible electronic device using an organic EL element, for example.

The inorganic thin film layer in the laminated body according to an embodiment of the present invention contains at least a silicon atom, an oxygen atom, and a carbon atom. The layer of an inorganic material containing such atoms is preferably formed by a chemical vapor deposition method (CVD method) from the viewpoint of being easy to enhance the denseness and decrease defects such as fine voids and cracks. Among others, the layer of an inorganic material is more preferably formed by a plasma enhanced chemical vapor deposition method (PECVD method) using glow discharge plasma and the like. It is preferable to form the inorganic thin film layer by a plasma enhanced chemical vapor deposition method from the viewpoint of being easy to manufacture a laminated body having the above features in the depth profile measured using TOF-SIMS.

The present disclosure also provides a method for manufacturing a laminated body having the above features, which includes at least a step of forming an inorganic thin film layer on a base material containing at least a flexible base material by a chemical vapor deposition method. Specifically, in an embodiment of the present invention, the method for manufacturing a laminated body is a method for manufacturing a laminated body having a base material layer and an inorganic thin film layer, which includes at least a step of generating discharge plasma while supplying a deposition gas to a space between a first deposition roll and a second deposition roll that are disposed in a vacuum chamber and forming an inorganic thin film layer on a base material while transporting the base material using the first deposition roll and the second deposition roll and in which a first magnetic field forming apparatus is disposed in each deposition roll of the first deposition roll and the second deposition roll and one or more additional magnetic field forming apparatuses are disposed at a different position separated from a deposition gas supply portion farther than the first magnetic field forming apparatus.

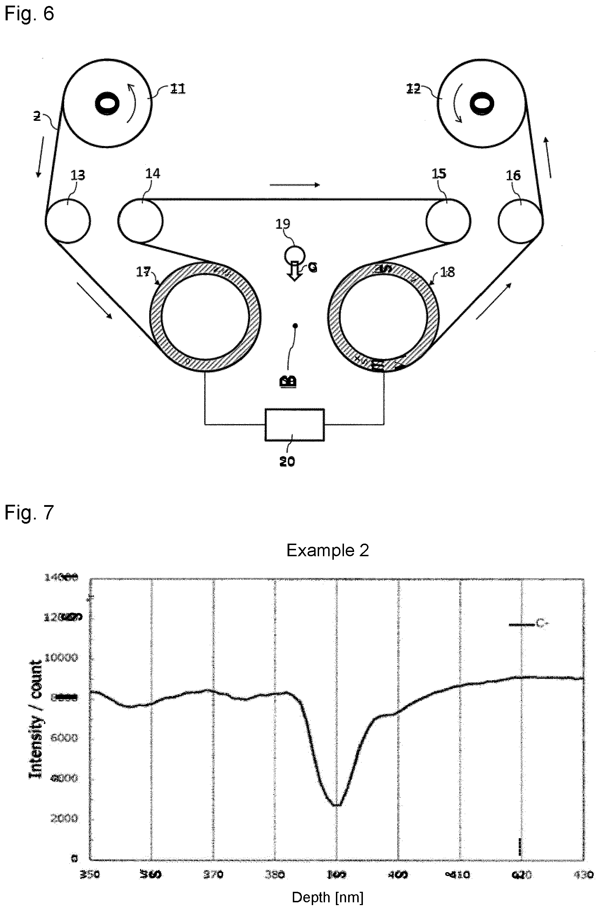

Fig. 6 is a schematic view illustrating an example of a manufacturing apparatus used in the method for manufacturing a laminated body according to an embodiment of the present invention, and the manufacturing apparatus is an apparatus for forming an inorganic thin film layer by a plasma enhanced chemical vapor deposition method. In Fig. 6, the dimensions, ratios and the like of the constituent parts are appropriately changed in order to make the drawings easier to see.

The manufacturing apparatus illustrated in Fig. 6 is equipped with a delivery roll 11, a wind-up roll 12, transport rolls 13 to 16, a first deposition roll 17, a second deposition roll 18, a gas supply pipe 19, and a power supply for plasma generation 20. Although not illustrated, in an example of a laminated body manufacturing apparatus, at least one, preferably two or more magnetic field forming apparatuses are disposed inside each of the first deposition roll 17 and the second deposition roll 18. In a case in which two or more magnetic field forming apparatuses are disposed, it is easy to manufacture a laminated body having the above features in the depth profile measured using TOF-SIMS.

Among the constituent parts of the manufacturing apparatus illustrated in Fig. 6, the first deposition roll 17, the second deposition roll 18, the gas supply pipe 19, and the magnetic field forming apparatus disposed in the first deposition roll 17 and the second deposition roll 18 are disposed in a vacuum chamber (not illustrated) when the laminated film is manufactured. This vacuum chamber is connected to a vacuum pump (not illustrated). The pressure inside the vacuum chamber is adjusted by the operation of the vacuum pump. When this apparatus is used, discharge plasma of the deposition gas supplied from the gas supply pipe 19 can be generated in the space between the first deposition roll 17 and the second deposition roll 18 by controlling the power supply for plasma generation 20, and plasma enhanced CVD can be performed by a continuous deposition process using the generated discharge plasma.

A base material 2 before deposition is disposed on the delivery roll 11 in a wound state, and the base material 2 is delivered while being unwound in the elongated direction. The wind-up roll 12 is provided on the end side of the base material 2, and the base material 2 after being subjected to deposition is wound up while being pulled and accommodated in a roll shape. The first deposition roll 17 and the second deposition roll 18 extend in parallel and are disposed to be opposed to each other. Both rolls are formed of a conductive material, and at least a part thereof is in contact with the base material 2, and each roll transports the base material 2 while rotating. It is preferable to use the first deposition roll 17 and the second deposition roll 18 which have the same diameter.

The first deposition roll 17 and the second deposition roll 18 are insulated from each other and connected to the common power supply for plasma generation 20. When an AC voltage is applied from the power supply for plasma generation 20, an electric field is formed in a space SP between the first deposition roll 17 and the second deposition roll 18. It is preferable that the power supply for plasma generation 20 can provide an applied power of 100 W to 10 kW and an AC frequency of 50 Hz to 500 kHz.

The magnetic field forming apparatus disposed in the first deposition roll 17 and the second deposition roll 18 is a member that forms a magnetic field in the space SP and is housed inside the first deposition roll 17 and the second deposition roll 18. The magnetic field forming apparatus is fixed so as not to rotate together with the first deposition roll 17 and the second deposition roll 18 (that is, the relative attitude to the vacuum chamber does not change).

The magnetic field forming apparatus disposed in the first deposition roll 17 and the second deposition roll 18 includes a central magnet extending in the same direction as the extending direction of the first deposition roll 17 and the second deposition roll 18 and an annular external magnet that is disposed so as to extend in the same direction as the extending direction of the first deposition roll 17 and the second deposition roll 18 while surrounding the central magnet. One ends of the central magnet and the external magnet may be fixed by a fixing member so that the external magnet is disposed to surround the central magnet.

Each magnetic field forming apparatus is disposed so that the magnetic field forming portion thereof faces the outside of the deposition roll instead of the rotation axis side of the deposition roll, faces the surface where the base material and the deposition roll are in contact with each other, and faces the atmosphere direction in which the deposition gas is supplied. The fact that the magnetic field forming portion faces the outside of the deposition roll specifically indicates that the magnetic field forming portion is disposed so as to face the outside of the deposition roll in a state in which the shortest distance between the central magnet and the inside of the deposition roll is less than or equal to the radius of the deposition roll and the side of the fixing member that is arbitrarily equipped on the side opposite to the magnetic field forming portion faces the rotation axis side of the deposition roll. The fact that the magnetic field forming portion faces the surface where the base material and the deposition roll are in contact with each other indicates that the magnetic field forming portion faces the outside of each deposition roll within the range in which the magnetic field forming portion faces the contacting surface. The fact that the magnetic field forming portion faces the atmosphere direction in which the deposition gas is supplied indicates that the magnetic field forming portion faces the direction of the space in which the deposition gas supplied from the gas supply pipe 19 exists.

In a case in which two or more magnetic field forming apparatuses are disposed in each deposition roll, each magnetic field forming apparatus is disposed so as to face the above direction. When the magnetic field forming apparatus disposed at the position closest to the gas supply pipe 19 among the two or more magnetic field forming apparatuses disposed in the first deposition roll 17 is denoted as the magnetic field forming apparatus A1 and the magnetic field forming apparatus disposed at the position closest to the gas supply pipe 19 among the two or more magnetic field forming apparatuses disposed in the second deposition roll 18 is denoted as the magnetic field forming apparatus B1, it is preferable that the magnetic field forming apparatus A1 and the magnetic field forming apparatus B1 are disposed so as to be substantially opposed to each other. By disposing each magnetic field forming apparatus as described above, it is easy to increase the amount of $O_2^-$ with respect to that of $Si^-$ in the region adjacent to the interface between the inorganic thin film layer and the base material and to manufacture a laminated body having the above features in the depth profile measured using TOF-SIMS.

For example, in a case in which two magnetic field forming apparatuses are disposed inside each of the first deposition roll 17 and the second deposition roll 18, when the two magnetic field forming apparatuses disposed inside the first deposition roll 17 are denoted as magnetic field forming apparatuses A1 and A2 and the two magnetic field forming apparatuses disposed inside the second deposition roll 18 are denoted as magnetic field forming apparatuses B1 and B2, A1 and A2 are disposed so that the magnetic field forming portion of each of A1 and A2 faces the outside of the first deposition roll 17 instead of the rotation axis side of the first deposition roll 17, faces the surface where the base material 2 and the first deposition roll 17 are in contact with each other, and faces the atmosphere direction in which the deposition gas is supplied. B1 and B2 are disposed so that the magnetic field forming portion of each of B1 and B2 faces the outside of the second deposition roll 18 instead of the rotation axis side of the second deposition roll 18, faces the surface where the base material 2 and the second deposition roll 18 are in contact with each other, and faces the atmosphere direction in which the deposition gas is supplied.

In a preferred embodiment of the present invention, in a case in which two magnetic field forming apparatuses are disposed inside each of the first deposition roll 17 and the second deposition roll 18 as described above, it is preferable that the magnetic field forming apparatus A1 and the magnetic field forming apparatus B1 are disposed so that the magnetic field forming portion of each of these apparatuses faces the deposition space SP side and these apparatuses are substantially opposed to each other between the two deposition rolls. The magnetic field forming apparatuses A2 and B2 are disposed at a position separated from the gas supply pipe farther than the magnetic field forming apparatuses A1 and B1 so that the magnetic field forming portions thereof face the outside of the deposition roll instead of the rotation axis side of the deposition roll, face the surface where the base material and the deposition roll are in contact with each other, and face the atmosphere direction in which the deposition gas is supplied. For example, the magnetic field forming apparatus A2 is disposed at a position that is separated from the gas supply pipe farther than the magnetic field forming apparatus A1 and at which the magnetic field forming apparatus A1 is rotated clockwise around the rotation axis of the first deposition roll 17 in the range in which the magnetic field forming portion of the magnetic field forming apparatus A2 faces the surface where the base material 2 and the first deposition roll 17 are in contact with each other, and the magnetic field forming apparatus B2 is disposed at a position that is separated from the gas supply pipe farther than the magnetic field forming apparatus B1 and at which the magnetic field forming apparatus B1 is rotated counterclockwise around the rotation axis of the second deposition roll 18 in the range in which the magnetic field forming portion of the magnetic field forming apparatus B1 faces the surface where the base material 2 and the second deposition roll 18 are in contact with each other.

In a case in which more magnetic field forming apparatuses are disposed as well, in addition to the magnetic field forming apparatuses A1 and B1 which are substantially opposed to each other as described above, the further magnetic field forming apparatuses are disposed at a position separated from the gas supply pipe farther than the magnetic field forming apparatuses A1 and B1 so that the magnetic field forming portions thereof face the outside of the deposition roll instead of the rotation axis side of the deposition roll, face the surface where the base material and the deposition roll are in contact with each other, and face the atmosphere direction in which the deposition gas is supplied. For example, one or more further magnetic field forming apparatuses may be disposed at a position that is separated from the gas supply pipe farther than the magnetic field forming apparatus A1 and at which the magnetic field forming apparatus A1 is rotated clockwise around the rotation axis of the first deposition roll 17 in the range in which the magnetic field forming portion of the magnetic field forming apparatus A2 faces the surface where the base material 2 and the first deposition roll 17 are in contact with each other, and one or more further magnetic field forming apparatuses may be disposed at a position that is separated from the gas supply pipe farther than the magnetic field forming apparatus B1 and at which the magnetic field forming apparatus B1 is rotated counterclockwise around the rotation axis of the second deposition roll 18 in the range in which the magnetic field forming portion of the magnetic field forming apparatus B2 faces the surface where the base material 2 and the second deposition roll 18 are in contact with each other.

In each magnetic field forming apparatus, the lines of magnetic force (magnetic fields) linking the central magnet and the external magnet form an endless tunnel. The discharge plasma of the deposition gas is generated by the magnetron discharge in which the lines of magnetic force intersect the electric field formed between the first deposition roll 17 and the second deposition roll 18. In other words, as to be described in detail later, the space SP is used as the deposition space for performing plasma enhanced CVD, and a thin film layer in which the deposition gas is deposited via the plasma state is formed on the surface (deposition surface), that is not in contact with the first deposition roll 17 and the second deposition roll 18, of the base material 2. The gas supply pipe 19 for supplying a deposition gas G such as a source gas for plasma enhanced CVD to the space SP is provided in the vicinity of the space SP. The gas supply pipe 19 has a tubular shape extending in the same direction as the extending direction of the first deposition roll 17 and the second deposition roll 18, and the deposition gas G is supplied to the space SP through openings provided at a plurality of locations. In the drawing, the situation in which the deposition gas G is supplied from the gas supply pipe 19 toward the space SP is indicated by an arrow.

An example of a source gas to be used in the chemical vapor deposition method is an organosilicon compound containing a silicon atom and a carbon atom. Examples of such an organosilicon compound include hexamethyldisiloxane, 1,1,3,3-tetramethyldisiloxane, vinyltrimethylsilane, methyltrimethylsilane, hexamethyldisilane, methylsilane, dimethylsilane, trimethylsilane, diethylsilane, propylsilane, phenylsilane, vinyltriethoxysilane, vinyltrimethoxysilane, tetramethoxysilane, tetraethoxysilane, phenyltrimethoxysilane, methyltriethoxysilane, and octamethylcyclotetrasiloxane. Among these organosilicon compounds, hexamethyldisiloxane and 1,1,3,3-tetramethyldisiloxane are preferable from the viewpoint of the handleability of compound and the properties such as gas barrier property of the inorganic thin film layer to be obtained. As the source gas, these organosilicon compounds may be used singly or in combination of two or more thereof.

A reactant gas capable of forming an inorganic compound such as an oxide or a nitride by the reaction with the source gas can be appropriately selected and mixed with the source gas. As the reactant gas for forming an oxide, for example, oxygen and ozone can be used. As the reactant gas for forming a nitride, for example, nitrogen and ammonia can be used. These reactant gases can be used singly or in combination of two or more thereof, and a reactant gas for forming an oxide and a reactant gas for forming a nitride can be used in combination, for example, in the case of forming an oxynitride. The flow ratio of the source gas to the reactant gas can be appropriately adjusted according to the atomic ratio of the inorganic material to be deposited.

In order to supply the source gas into the vacuum chamber, a carrier gas may be used if necessary. A discharge gas may be used if necessary in order to generate plasma discharge. As such carrier gas and discharge gas, known gases can be appropriately used. For example, rare gases such as helium, argon, neon, and xenon; and hydrogen can be used.

The pressure (degree of vacuum) in the vacuum chamber can be appropriately adjusted depending on the kind of source gas and the like but is preferably 0.5 to 50 Pa. In a case in which the plasma enhanced CVD method is changed to a low-pressure plasma enhanced CVD method for the purpose of suppressing the gas phase reaction, the pressure is usually 0.1 to 10 Pa. The electric power of the electrode drum in the plasma generator can be appropriately adjusted depending on the kind of source gas, the pressure in the vacuum chamber, and the like and is preferably 0.1 to 10 kW.

The transport velocity (line speed) of the base material may be appropriately adjusted depending on the kind of source gas, the pressure in the vacuum chamber, and the like but is preferably 0.1 to 100 m/min, more preferably 1 to 20 m/min, still more preferably 3 to 15 m/min from the viewpoint of being easy to set the standard deviation of the composition distribution in the depth direction (thickness direction) of the inorganic thin film layer to a predetermined range and to enhance the gas barrier property and from the viewpoint of easily reducing the thermal damage to the base material during deposition of the inorganic thin film layer. When the line speed is in the above range, there is a tendency that wrinkling caused by heat is less likely to occur since the thermal damage to the base material is reduced and there is a tendency that the uniformity of the formed inorganic thin film layer is enhanced as well as the film thickness is less likely to be thinned.

An example of the step of laminating the inorganic thin film layer on the base material will be described in more detail with reference to Fig. 6.

First, before deposition, it is preferable to perform a pretreatment so that the outgas generated from the base material 2 is sufficiently reduced. The amount of outgas generated from the base material 2 can be judged by using the pressure when the base material 2 is set in the manufacturing apparatus and the pressure in the apparatus (in the chamber) is reduced. For example, when the pressure in the chamber of the manufacturing apparatus is $1 \times 10^{-3}$ Pa or less, it can be judged that the amount of outgas generated from the base material 2 is sufficiently small. Examples of the method for reducing the amount of outgas generated from the base material 2 include vacuum drying, heat drying, drying by the combination thereof, and drying by natural drying. Regardless of the drying method, it is preferable to repeatedly rewind (unwind and wind) the roll during drying and to expose the entire base material 2 to the drying environment in order to promote the drying of the inside of the base material 2 wound in a roll shape.

Vacuum drying is performed by placing the base material 2 in a pressure resistant vacuum vessel and evacuating the inside of the vacuum vessel using a decompressor such as a vacuum pump to create a vacuum. The pressure in the vacuum vessel at the time of vacuum drying is preferably 1000 Pa or less, more preferably 100 Pa or less, still more preferably 10 Pa or less. Evacuation in the vacuum vessel may be continuously performed by continuously operating the decompressor or may be intermittently performed by intermittently operating the decompressor while managing the internal pressure so as not to exceed a certain level. The drying time is preferably 8 hours or more, more preferably 1 week or more, still more preferably 1 month or more.

The heat drying may be performed by exposing the base material 2 to an environment at, for example, 50°C or more. The heating temperature is preferably 50°C to 200°C, more preferably 70°C to 150°C. When the heating temperature is in the above range, there is a tendency that the base material 2 is less likely to be deformed and there is a tendency that defects are less likely to be generated since the oligomer component is less likely to elute from the base material 2 and precipitate on the surface. The drying time can be appropriately selected depending on the heating temperature and the heating means used. The heating means is not particularly limited as long as the base material 2 can be heated to, for example, the above temperature at normal pressure. Among the commonly known apparatuses, an infrared heating apparatus, a microwave heating apparatus, and a heating drum are preferably used.

An infrared heating apparatus is an apparatus that heats an object by radiating infrared rays from an infrared generating means. A microwave heating apparatus is an apparatus that heats an object by irradiating the object with a microwave from a microwave generating means. A heating drum is an apparatus that heats the drum surface and brings an object into contact with the drum surface to heat the object by heat conduction from the contact portion.

Natural drying is performed by, for example, placing the base material 2 in a low humidity atmosphere and allowing a dry gas such as dry air or dry nitrogen to pass through to maintain the low humidity atmosphere. When natural drying is performed, it is preferable to place a desiccant such as silica gel together in the low humidity environment in which the base material 2 is placed. The drying time is preferably 8 hours or more, more preferably 1 week or more, still more preferably 1 month or more. These dryings may be performed separately before the base material 2 is set in the manufacturing apparatus or may be performed in the manufacturing apparatus after the base material 2 is set in the manufacturing apparatus. Examples of the method for drying the base material 2 after being set in the manufacturing apparatus include a method in which the pressure in the chamber is reduced while delivering and transporting the base material 2 from the delivery roll. The roll through which the base material 2 passes may be equipped with a heater and heated, and the base material 2 may be heated by using the heated roll as the heating drum described above.

Examples of another method for reducing the outgas from the base material 2 include a method in which an inorganic film is formed on the surface of the base material 2 in advance. Examples of the method for forming an inorganic film include physical deposition methods such as vacuum deposition (heat deposition), electron beam (EB) deposition, sputtering, and ion plating. The inorganic film may be formed by chemical deposition methods such as thermal CVD, plasma enhanced CVD, and atmospheric pressure CVD. The influence of outgas may be further reduced by subjecting the base material 2 having an inorganic film formed on the surface to a drying treatment by the drying methods described above.

Next, the inside of the vacuum chamber (not illustrated) is put into a reduced pressure environment, and the electric power is applied to the first deposition roll 17 and the second deposition roll 18 to generate an electric field in the space SP. At this time, since the magnetic field forming apparatuses disposed inside the first deposition roll 17 and the second deposition roll 18 each form an endless tunnel-shaped magnetic field described above, the magnetic field and the electrons emitted into the space SP form discharge plasma of the donut-shaped deposition gas along the tunnel as the deposition gas is introduced. Since this discharge plasma can be generated at a low pressure of about several Pa, the temperature inside the vacuum chamber can be set to about room temperature.

Meanwhile, since the temperature of the electrons captured at high density in the magnetic field formed by the magnetic field forming apparatuses disposed inside the first deposition roll 17 and the second deposition roll 18 is high, discharge plasma is generated by the collision between the electrons and the deposition gas. In other words, a high-density discharge plasma is formed in the space SP as electrons are confined in the space SP by the magnetic field and electric field formed in the space SP. More specifically, high-density (high-intensity) discharge plasma is formed in the space that overlaps the endless tunnel-shaped magnetic field, and low-density (low-intensity) discharge plasma is formed in the space that does not overlap the endless tunnel-shaped magnetic field. The intensity of these discharge plasmas continuously changes. When the discharge plasma is generated, a large number of radicals and ions are generated, the plasma reaction proceeds, and the reaction between the source gas and reactant gas contained in the deposition gas occurs. For example, an organosilicon compound that is a source gas reacts with oxygen that is a reactant gas, and an oxidation reaction of the organosilicon compound occurs. Here, in the space in which the high-intensity discharge plasma is formed, there is a large quantity of energy to be applied for the oxidation reaction, thus the reaction is likely to proceed, and mainly a complete oxidation reaction of organosilicon compound is likely to occur. Meanwhile, in the space in which the low-intensity discharge plasma is formed, there is a small quantity of energy to be applied for the oxidation reaction, thus the reaction is less likely to proceed, and mainly an incomplete oxidation reaction of organosilicon compound is likely to occur. In the present specification, the "complete oxidation reaction of organosilicon compound" means that the reaction between an organosilicon compound and oxygen proceeds and the organosilicon compound is oxidatively decomposed into silicon dioxide ($SiO_2$) and water and carbon dioxide.

For example, in a case in which the deposition gas contains hexamethyldisiloxane (HMDSO: $(CH_3)_6Si_2O$) that

is a source gas and oxygen ($O_2$) that is a reactant gas, the reaction as represented by Reaction Formula (9) occurs and silicon dioxide is produced in the case of "complete oxidation reaction".
[Math. 9]

$$(CH_3)_6Si_2O + 12O_2 \rightarrow 6CO_2 + 9H_2O + 2SiO_2 \qquad (9)$$

In the present specification, the "incomplete oxidation reaction of organosilicon compound" means that an organosilicon compound does not undergo a complete oxidation reaction but a reaction occurs in which $SiO_xC_y$ ($0 < x < 2$, $0 < y < 2$) containing carbon in the structure is produced instead of $SiO_2$.

As described above, in the manufacturing apparatus as illustrated in Fig. 6, the discharge plasma is formed in a donut shape on the surfaces of the first deposition roll 17 and the second deposition roll 18, and thus the base material 2 to be transported on the surfaces of the first deposition roll 17 and the second deposition roll 18 alternately passes through the space in which the high-intensity discharge plasma is formed and the space in which the low-intensity discharge plasma is formed. Hence, the portion containing a large amount of $SiO_2$ produced by the complete oxidation reaction and the portion containing a large amount of $SiO_xC_y$ produced by the incomplete oxidation reaction alternately formed on the surface of the base material 2 to pass through the surfaces of the first deposition roll 17 and the second deposition roll 18. In other words, a thin film layer is formed which alternately has a portion where the complete oxidation reaction is likely to proceed and the carbon atom content is low and a portion where the incomplete oxidation reaction is likely to proceed and the carbon atom content is high. For this reason, the ionic strength curve of $C^-$ in the thin film layer acquired by TOF-SIMS measurement has extreme values (maximum value and minimum value).

In the ionic strength curve of $C^-$ acquired by TOF-SIMS measurement, the minimum value, maximum value, smallest value, and greatest value (collectively referred to as X value in some cases) can be adjusted by changing the ratio of the supplied reactant gas to the supplied source gas. For example, when the ratio of the reactant gas to the source gas is increased, the average value of the carbon atom ratio decreases, and the X value can be decreased. This is because the amount of source gas relatively decreases and the reaction condition approaches a reaction condition in which the source gas is likely to undergo complete oxidation. On the other hand, when the ratio of the reactant gas to the source gas is decreased, the average value of the carbon atom ratio increases, and the X value can be increased. This is because the amount of source gas relatively increases and the reaction condition becomes a reaction condition in which the source gas is likely to undergo incomplete oxidation. When the ratio of the reactant gas to the source gas is not changed but the total amount of deposition gas is increased, the average value of the carbon atom ratio increases, and the X value can be increased. This is because the source gas obtains a relatively decreased quantity of energy from the discharge plasma when the total amount of deposition gas is large and the reaction condition becomes a reaction condition in which the source gas is likely to undergo incomplete oxidation. Here, examples of the method for increasing the ratio of the reactant gas to the source gas include a method in which only the amount of source gas is decreased, a method in which the amount of source gas is decreased and the amount of reactant gas is increased, or a method in which only the amount of reactant gas is increased. The minimum value, maximum value, greatest value, and smallest value in the ionic strength curve of $C^-$ acquired by TOF-SIMS measurement can be adjusted to predetermined ranges by appropriately adjusting the ratio of the reactant gas to the source gas.

The laminated body according to an embodiment of the present invention may have a protective layer on the surface of the inorganic thin film layer on the side opposite to the base material layer. By having a protective layer, the laminated body or the flexible electronic device including the laminated body can be protected from scratches, dirt, dust and the like. The protective layer is preferably a coating film that is obtained from a coating liquid containing a silicon compound and subjected to a modification treatment from the viewpoint of securing the adhesive property to the inorganic thin film layer.

The silicon compound is preferably a polysiloxane compound, a polysilazane compound, a polysilane compound, or a mixture thereof. In particular, inorganic silicon compounds such as hydrogenated silsesquioxane and perhydropolysilazane are preferable from the viewpoint of achieving both flexibility and surface hardness. Examples of perhydropolysilazane include AZ inorganic silazane coating materials (NAX series, NL series, and NN series) manufactured by Performance Materials business sector of Merck KGaA.

Examples of the method for applying a coating liquid containing a silicon compound include various coating methods conventionally used, for example, methods such as spray coating, spin coating, bar coating, curtain coating, dipping method, air knife method, slide coating, hopper coating, reverse roll coating, gravure coating, and extrusion coating.

The thickness of the protective layer is appropriately set depending on the purpose but is in a range of, for example, 10 nm to 10 $\mu$m, more preferably 100 nm to 1 $\mu$m. The protective layer is preferably flat, and the average surface roughness acquired by observation under a white interference microscope is preferably 50 nm or less, more preferably 10 nm or less. The thickness of the protective layer can be measured using a film thickness meter.

Upon the formation of the protective layer, the film thickness can be adjusted to a desired film thickness by one time of coating or by plural times of coating. In the case of performing plural times of coating, it is preferable to perform the modification treatment for every time of coating.

Examples of the modification treatment method of the coating film when the protective layer is formed include heat treatment, wet heat treatment, plasma treatment, ultraviolet irradiation treatment, excimer irradiation treatment (vacuum ultraviolet irradiation treatment), electron beam irradiation treatment, and ion implantation treatment. Excimer irradiation treatment, ion implantation treatment and the like are preferable from the viewpoint of efficiently modifying the surface and/or inside of the coating film to silicon oxide or silicon oxynitride at a low temperature.

(Base material layer)

In the laminated body according to an embodiment of the present invention, the base material layer contains at least a flexible base material. The flexible base material is a base material which exhibits flexibility and thus can hold the inorganic thin film layer. As the flexible base material, it is possible to use a resin film containing at least one resin as a resin component. The flexible base material is preferably a transparent resin base material. Examples of the resin which can be used in the flexible base material include polyester resins such as polyethylene naphthalate (PEN); polyolefin resins such as polyethylene (PE), polypropylene (PP), and cyclic polyolefin; polyamide resins; polycarbonate resins; polystyrene resins; polyvinyl alcohol resins; saponified products of ethylene-vinyl acetate copolymer; polyacrylonitrile resins; acetal resins; polyimide resins; polyether sulfide (PES), and polyethylene terephthalate (PET) subjected to biaxial stretching and thermal annealing treatment. As the flexible base material, the resins may be used singly or in combination of two or more thereof. Among these, it is preferable to use a resin selected from the group consisting of polyester resins and polyolefin resins, it is more preferable to use a resin selected from the group consisting of PEN and cyclic polyolefin, and it is still more preferable to use PEN as the flexible base material from the viewpoint of easily enhancing the heat resistance of the laminated body to be obtained and from the viewpoint of easily enhancing the transparency.

The flexible base material may be an unstretched resin base material or a stretched resin base material obtained by stretching an unstretched resin base material in the flow direction (MD direction) of the resin base material and/or in a direction (TD direction) perpendicular to the flow direction of the resin base material by known methods such as uniaxial stretching, tenter-type sequential biaxial stretching, tenter-type simultaneous biaxial stretching, and tubular simultaneous biaxial stretching. The flexible base material may be a laminated body in which two or more layers of the resins described above are laminated. It is preferable to use a stretched resin base material that is uniaxially stretched or biaxially stretched from the viewpoint of preventing deformation of the base material in the step of laminating the inorganic thin film layer and of easily manufacturing a laminated body having the above features in the depth profile measured using TOF-SIMS.

The glass transition temperature (Tg) of the flexible base material is preferably 100°C or more, more preferably 130°C or more, still more preferably 150°C or more from the viewpoint of heat resistance of the laminated body. The upper limit of the glass transition temperature is preferably 250°C or less. The glass transition temperature (Tg) can be measured using a dynamic viscoelasticity measuring (DMA) apparatus or a differential scanning calorimeter (DSC).

The thickness of the flexible base material may be appropriately set in consideration of stability and the like when the laminated body is manufactured but is preferably 5 to 500 $\mu$m from the viewpoint of facilitating the transportation of the flexible base material in a vacuum. In a case in which the inorganic thin film layer is formed by the plasma enhanced CVD method to be described later, the thickness of the flexible base material is more preferably 10 to 200 $\mu$m, still more preferably 15 to 150 $\mu$m. The thickness of the flexible base material is measured using a dial gauge or an interference type thickness gauge.

The flexible base material may be a retardation film in which two in-plane orthogonal components have different refractive indices from each other, such as a $\lambda$/4 retardation film and a $\lambda$/2 retardation film. Examples of the material for the retardation film include cellulose-based resins, polycarbonate-based resins, polyarylate-based resins, polyester-based resins, acrylic resins, polysulfone-based resins, polyethersulfone-based resins, cyclic olefin-based resins, and oriented and solidified layers of liquid crystal compounds. As the film forming method, it is possible to use a solvent casting method and a precision extrusion method which can decrease the residual stress of the film, but a solvent casting method is preferably used from the viewpoint of uniformity. The stretching method is not particularly limited, and it is possible to apply longitudinal uniaxial stretching in between rolls, horizontal uniaxial stretching in a tenter, and the like that can provide uniform optical properties.

In a case in which the flexible base material is a $\lambda$/4 retardation film, the in-plane retardation Re (550) at a wavelength of 550 nm is preferably 100 to 180 nm, more preferably 110 to 170 nm, still more preferably 120 to 160 nm.

In a case in which the flexible base material is a $\lambda$/2 retardation film, the in-plane retardation Re (550) at a wavelength of 550 nm is preferably 220 to 320 nm, more preferably 240 to 300 nm, still more preferably 250 to 280 nm.

In a case in which the flexible base material is a retardation film, the retardation film may exhibit reverse wavelength dispersion property in which the retardation value increases according to the wavelength of the measured light, positive wavelength dispersion property in which the retardation value decreases according to the wavelength of the measured light, or flat wavelength dispersion property in which the retardation value hardly changes depending on the wavelength of the measured light.

In a case in which the flexible base material is a retardation film exhibiting reverse wavelength dispersion property, the flexible base material can satisfy Re (450)/Re (550) < 1 and Re (650)/Re (550) > 1, where Re ($\lambda$) denotes the retardation of the flexible base material at a wavelength $\lambda$.

The flexible base material is preferably colorless and transparent from the viewpoint of being able to transmit or absorb light and from the viewpoint of easily enhancing the visibility of the laminated body. More specifically, the total light transmittance through the flexible base material is preferably 80% or more, more preferably 85% or more.

The haze (cloud value) of the flexible base material is preferably 5% or less, more preferably 3% or less, still more preferably 1% or less.

The flexible base material preferably has insulation property and an electric resistivity of $10^6$ $\Omega$cm or more from the viewpoint of being able to be used as a base material for organic devices and energy devices.

The surface of the flexible base material may be subjected to a surface activation treatment for cleaning the surface from the viewpoint of adhesive property to an organic layer and the like. Examples of such a surface activation treatment include a corona treatment, a plasma treatment, and a flame treatment.

The flexible base material may be a base material that is subjected to an annealing treatment or a base material that is not subjected to an annealing treatment. The flexible base material is preferably a base material that is subjected to an annealing treatment from the viewpoint of enhancing the thermal dimensional stability of the laminated body and easily improving the heat resistance Examples of the method of annealing treatment include a method in which the flexible base material is heated at a temperature equal to or more than the upper limit of working temperature (for example, 200°C) while being biaxially stretched and a method in which the flexible base material is biaxially stretched and then allowed to pass offline through a heating furnace having a temperature equal to or more than the upper limit of working temperature (for example, 200°C).

In the laminated body according to an embodiment of the present invention, the base material layer may include one or more organic layers in addition to the flexible base material. Examples of the organic layer include an undercoat layer, a flattening layer, an anti-blocking layer, a primer layer, an easy-adhesion layer, a curl adjusting layer, a stress relaxation layer, and a heat resistant layer. In an embodiment of the present invention, the flexible base material and the portion where an organic layer as described above is laminated are combined to form the base material layer.

In the laminated body according to an embodiment of the present invention, it is preferable that the base material layer includes at least one organic layer and it is more preferable that the base material layer includes at least one organic layer at the position adjacent to the inorganic thin film layer. In other words, it is preferable to have at least one organic layer between the flexible base material and inorganic thin film layer included in the base material layer. In this embodiment, the laminated body may have a further organic layer laminated on another portion. The organic layer may be a layer having a function as a flattening layer, a layer having a function as an anti-blocking layer, or a layer having both of these functions. The organic layer may be a single layer or multilayer composed of two or more layers. In a case in which the laminated body includes two or more organic layers, these organic layers may be layers having the same composition or layers having different compositions.

The thickness of the organic layer may be appropriately adjusted depending on the application and is preferably 0.1 to 5 $\mu$m, more preferably 0.5 to 3 $\mu$m, still more preferably 0.7 to 3 $\mu$m. The thickness of the organic layer can be measured using a film thickness meter. When the thickness is in the above range, the surface hardness of the laminated body tends to be high and the bending property tends to be favorable. In a case in which the laminated body includes two or more organic layers, the thicknesses of the respective organic layers may be the same as or different from one another. In a case in which the laminated body has three or more organic layers, each organic layer can have the above-mentioned thickness.

The organic layer can be formed by, for example, applying a composition containing a photocurable compound having a polymerizable functional group onto the primer layer, if necessary, and curing the composition. Examples of the photocurable compound contained in the composition for forming the organic layer include ultraviolet or electron beam curable compounds. Examples of such compounds include compounds having one or more polymerizable functional groups in the molecule, for example, compounds having polymerizable functional groups such as a (meth)acryloyl group, a vinyl group, a styryl group, and an allyl group. The composition for forming the organic layer (referred to as the composition for organic layer formation in some cases) may contain one photocurable compound or two or more photocurable compounds. The photocurable compound having a polymerizable functional group, which is contained in the composition for organic layer formation is polymerized by being cured, and an organic layer containing a polymer of the photocurable compound is formed.

The reaction rate of the polymerizable functional group of the photocurable compound having a polymerizable functional group in the organic layer is preferably 70% or more, more preferably 75% or more, still more preferably 80% or more from the viewpoint of easily enhancing the appearance quality. The upper limit of the reaction rate is not particularly limited but is preferably 95% or less, more preferably 90% or less from the viewpoint of easily enhancing the appearance quality. When the reaction rate is in the above range, the organic layer to be obtained is likely to be colorless and transparent and the bending resistance thereof is likely to be favorable. The reaction rate increases as the polymerization reaction of the photocurable compound having a polymerizable functional group proceeds and thus can be increased by increasing the intensity of ultraviolet light for irradiation or increasing the irradiation time, for example, in a case in which the photocurable compound is an ultraviolet curable compound. The reaction rate can be set to be in the above range by adjusting the curing conditions as described above.

The reaction rate can be acquired by measuring the infrared absorption spectrums on the coating film surfaces of a coating film before curing obtained by coating a base material with a composition for organic layer formation and drying the composition if necessary and a coating film obtained by curing this coating film using total reflection type FT-IR and determining the amount of change in the intensity of the peak attributed to the polymerizable functional group. For example, in a case in which the polymerizable functional group is a (meth)acryloyl group, the C=C double bond moiety in the (meth)acryloyl group is a group involved in the polymerization, and the intensity of the peak attributed to the C=C double bond decreases as the reaction rate of polymerization increases. On the other hand, the C=O double bond moiety in the (meth)acryloyl group is not involved in the polymerization, and the intensity of the peak attributed to the C=O double bond does not change after the polymerization. For this reason, the reaction rate can be calculated by comparing the proportion ($I_{CC1}/I_{CO1}$) of the intensity ($I_{CC1}$) of the peak attributed to the C=C double bond to the intensity ($I_{CO1}$) of the peak attributed to the C=O double bond in the (meth)acryloyl group in the infrared absorption spectrum measured for the coating film before curing with the proportion ($I_{CC2}/I_{CO2}$) of the intensity ($I_{CC2}$) of the peak attributed to the C=C double bond to the intensity ($I_{CO2}$) of the peak attributed to the C=O double bond in the (meth)acryloyl group in the infrared absorption spectrum measured for the coating film after curing. In this case, the reaction rate is calculated by Equation (10):

[Math. 10]

$$\text{Reaction rate [\%]} = [1 - (I_{CC2}/I_{CO2})/(I_{CC1}/I_{CO1})] \times 100 \qquad (10)$$

The infrared absorption peak attributed to a C=C double bond is usually observed in the range of 1,350 to 1,450 cm$^{-1}$, for example, in the vicinity of 1,400 cm$^{-1}$ and the infrared absorption peak attributed to a C=O double bond is usually observed in the range of 1,700 to 1,800 cm$^{-1}$, for example, in the vicinity of 1,700 cm$^{-1}$.

It is preferable that $I_a$ and $I_b$ satisfy Equation (11) :
where $I_a$ denotes the intensity of the infrared absorption peak in the range of 1,000 to 1,100 cm$^{-1}$ and $I_b$ denotes the intensity of the infrared absorption peak in the range of 1,700 to 1,800 cm$^{-1}$ in the infrared absorption spectrum of the organic layer.

[Math. 11]

$$0.05 \leq I_b/I_a \leq 1.0 \quad (11)$$

Here, it is considered that the infrared absorption peak in the range of 1,000 to 1,100 cm$^{-1}$ is an infrared absorption peak attributed to a siloxane-derived Si-O-Si bond present in the compound and polymer (for example, a photocurable compound having a polymerizable functional group and/or a polymer thereof) contained in the organic layer and the infrared absorption peak in the range of 1,700 to 1,800 cm$^{-1}$ is an infrared absorption peak attributed to a C=O double bond present in the compound and polymer (for example, a photocurable compound having a polymerizable functional group and/or a polymer thereof) contained in the organic layer. The ratio ($I_b/I_a$) between the intensities of these peaks is considered to indicate the relative proportion of C=O double bonds to siloxane-derived Si-O-Si bonds in the organic layer. In a case in which the ratio ($I_b/I_a$) between the peak intensities is in the above predetermined range, the uniformity of the organic layer is easily enhanced and the adhesive property between layers, particularly adhesive property in a high humidity environment is easily enhanced. The ratio ($I_b/I_a$) between the peak intensities is preferably 0.05 or more, more preferably 0.10 or more, still more preferably 0.20 or more. In a case in which the ratio between the peak intensities is equal to or more than the lower limit, the uniformity of the organic layer is easily enhanced. This is considered to be because aggregates are generated in the organic layer and the layer embrittles in some cases when the number of siloxane-derived Si-O-Si bonds present in the compound and polymer contained in the organic layer is too large and the generation of such aggregates is easily diminished although the present disclosure is not limited to the mechanism to be described later at all. The ratio ($I_b/I_a$) between the peak intensities is preferably 1.0 or less, more preferably 0.8 or less, still more preferably 0.5 or less. In a case in which the ratio between the peak intensities is less than or equal to the upper limit, the adhesive property of the organic layer is easily enhanced. This is considered to be because the siloxane-derived Si-O-Si bonds are present in the compound and polymer contained in the organic layer in a certain amount or more and thus the hardness of the organic layer is properly decreased although the present disclosure is not limited to the mechanism to be described later at all. The infrared absorption spectrum of the organic layer can be measured using a Fourier transform type infrared spectrophotometer (FT/IR-460Plus manufactured by JASCO Corporation) equipped with an ATR attachment (PIKE MIRacle).

The photocurable compound contained in the composition for organic layer formation is a compound to be a resin which is a polymer as the polymerization thereof is initiated by ultraviolet light and the like and curing thereof proceeds. The photocurable compound is preferably a compound having a (meth)acryloyl group from the viewpoint of curing efficiency. The compound having a (meth)acryloyl group may be a monofunctional monomer or oligomer or a polyfunctional monomer or oligomer. In the present specification, "(meth)acryloyl" represents acryloyl and/or methacryloyl and "(meth)acryl" represents acryl and/or methacryl.

Examples of the compound having a (meth)acryloyl group include (meth)acrylic compounds, and specific examples thereof include alkyl (meth)acrylate, urethane (meth)acrylate, ester (meth)acrylate, epoxy (meth)acrylate, and polymers and copolymers thereof. Specific examples thereof include methyl (meth)acrylate, butyl (meth)acrylate, methoxyethyl (meth)acrylate, butoxyethyl (meth)acrylate, phenyl (meth)acrylate, ethylene glycol di(meth)acrylate, propylene glycol di(meth)acrylate, neopentyl glycol di(meth)acrylate, dipropylene glycol di(meth)acrylate, ethylene glycol di(meth)acrylate, propylene glycol di(meth)acrylate, pentaerythritol tri(meth)acrylate, and polymers and copolymers thereof.

The photocurable compound contained in the composition for organic layer formation preferably contains, for example, metetramethoxysilane, tetraethoxysilane, methyltrimethoxysilane, methyltriethoxysilane, ethyltrimethoxysilane, ethyltriethoxysilane, isopropyltrimethoxysilane, isobutyltrimethoxysilane, cyclohexyltrimethoxysilane, n-hexyltrimethoxysilane, n-octyltriethoxysilane, n-decyltrimethoxysilane, phenyltrimethoxysilane, dimethyldimethoxysilane, diisopropyldimethoxysilane, trimethylethoxysilane, and triphenylethoxysilane instead of the compound having a (meth)acryloyl group or in addition to the compound having a (meth)acryloyl group. Alkoxysilanes other than these may be used.

Examples of the photocurable compound other than the photocurable compound having a polymerizable functional group described above include monomers or oligomers to be resins such as polyester resin, isocyanate resin, ethylene vinyl alcohol resin, vinyl-modified resin, epoxy resin, phenol resin, urea melamine resin, styrene resin, and alkyl titanate by polymerization.

The composition for organic layer formation may contain inorganic particles. Examples of the inorganic particles include silica particles, alumina particles, calcium carbonate particles, magnesium carbonate particles, barium sulfate particles, aluminum hydroxide particles, titanium dioxide particles, zirconium oxide particles, clay, and talc. The average primary particle size of silica particles contained in the composition for organic layer formation is preferably 5 to 100 nm, more preferably 5 to 75 nm. When inorganic particles are contained, the heat resistance of the laminated film is easily improved. When the composition for organic layer formation contains the particles, the organic layer contains the particles.

The content of inorganic particles, preferably silica particles, is preferably 20% to 90% by mass, more preferably 40% to 85% by mass with respect to the mass of solid components in the composition for organic layer formation. When the content of inorganic particles is in the above range, the heat resistance of the laminated film is easily improved. The solid components in the composition for organic layer formation means components excluding volatile components such as a solvent contained in the composition for organic layer formation. Hence, the content of inorganic particles is also the content of inorganic particles in the organic layer which is contained in the laminated body depending on the circumstances.

The composition for organic layer formation may contain a photopolymerization initiator from the viewpoint of curability of the organic layer. The content of photopolymerization initiator is preferably 2% to 15% by mass, more preferably 3% to 11% by mass with respect to the mass of solid components in the composition for organic layer formation from the viewpoint of enhancing curability of the organic layer.

The composition for organic layer formation may contain a solvent from the viewpoint of coating property. As the solvent, a solvent capable of dissolving the photocurable compound having a polymerizable functional group can be appropriately selected depending on the kind of this compound. For example, the solvent is not particularly limited as long as it can dissolve the resin. Examples thereof include alcohol-based solvents, ether-based solvents, ketone-based solvents, aprotic polar solvents, ester-based solvents, nitrile-based solvents, hydrocarbon solvents, aromatic hydrocarbon solvents, and halogenated hydrocarbon solvents. The solvents may be used singly or in combination of two or more thereof.

In addition to the photocurable compound having a polymerizable functional group, the inorganic particles, the photopolymerization initiator, and the solvent, additives such as a thermal polymerization initiator, an antioxidant, an ultraviolet absorber, a plasticizer, a leveling agent, and a curl inhibitor may be contained if necessary.

The organic layer can be formed by, for example, applying a composition for organic layer formation (photocurable composition) containing a photocurable compound onto the primer layer, drying the composition if necessary, then irradiating the composition with ultraviolet light or electron beams, and thus curing the photocurable compound.

Examples of the coating method include various coating methods conventionally used, for example, methods such as spray coating, spin coating, bar coating, curtain coating, dipping method, air knife method, slide coating, hopper coating, reverse roll coating, gravure coating, and extrusion coating.

In a case in which the organic layer has a function as a flattening layer, the organic layer may contain (meth)acrylate resin, polyester resin, isocyanate resin, ethylene vinyl alcohol resin, vinyl-modified resin, epoxy resin, phenol resin, urea melamine resin, styrene resin, alkyl titanate, and the like. The organic layer may contain one of these resins or two or more of these resins in combination.

In a case in which the organic layer has a function as a flattening layer, it is preferable in the flattening layer that the temperature at which the elastic modulus of the flattening layer surface decreases by 50% or more is 150°C or more in a case in which the temperature dependent change of the elastic modulus of the flattening layer surface is evaluated using a rigid pendulum type physical property testing machine (for example, RPT-3000W manufactured by A & D Company, Limited).

In a case in which the organic layer has a function as a flattening layer, the surface roughness measured by observing the flattening layer under a white interference microscope is preferably 3 nm or less, more preferably 2 nm or less, still more preferably 1 nm or less. In a case in which the surface roughness of the flattening layer is less than or equal to the upper limit, there is an effect that defects of the inorganic thin film layer decrease and the gas barrier property is further enhanced. The surface roughness is measured by observing the flattening layer under a white interference microscope and forming interference fringes according to the irregularities of the sample surface.

In a case in which the organic layer has a function as an anti-blocking layer, the organic layer preferably contains particularly the inorganic particles described above.

(Layer configuration)

The layer configuration of the laminated body according to an embodiment of the present invention is not particularly limited as long as it has at least a base material layer containing at least a flexible base material and an inorganic thin film layer. Specifically, the layer configuration may be a two-layer configuration of flexible base material/inorganic thin film layer, a three-layer configuration of flexible base material/organic layer/inorganic thin film layer, a four-layer configuration of inorganic thin film layer/flexible base material/organic layer/inorganic thin film layer, organic layer/flexible base material/organic layer/inorganic thin film layer, flexible base material/organic layer/inorganic thin film layer/organic layer, or the like, or a configuration including 5 or more layers of inorganic thin film layer/organic layer/flexible base material/organic layer/inorganic thin film layer, organic layer/inorganic thin film layer/flexible base material/organic layer/inorganic thin film layer, organic layer/inorganic thin film layer/flexible base material/organic layer/inorganic thin film layer/organic layer, or the like. Each layer in the layer configuration of the laminated body may be a single layer or a multilayer. In an embodiment of the invention, in a case in which layers of two or more flexible base materials are included in the layer configuration of the laminated body, the two or more flexible base materials may be the same as or different from one another. The same applies to the case in which two or more organic layers or two or more inorganic thin film layers are included. Further layers may be included in addition to the layers described above. Examples of the further layers include an easy-slip layer, a hard coat layer, a transparent conductive film layer, a color filter layer, an easy-adhesion layer, a curl adjustment layer, a stress relaxation layer, a heat resistant layer, a scratch resistant layer, and a push-in resistant layer.

[Method for manufacturing laminated film]

The method for manufacturing a laminated body according to an embodiment of the present invention is not particularly limited as long as each layer can be formed. Example thereof include a method in which an organic layer is formed on one surface of a flexible base material if necessary and then an inorganic thin film layer is formed on the flexible base material or on the organic layer. The laminated body may be manufactured by separately fabricating the respective layers and sticking the layers together, but it is preferable to use a method in which an inorganic thin film layer is formed on a flexible base material or an organic layer from the viewpoint of easily manufacturing a laminated body having the above features in the depth profile measured using TOF-SIMS.

From the viewpoint of easily enhancing the denseness of the inorganic thin film layer and easily decreasing defects such as fine voids and cracks, it is preferable that the laminated body is manufactured by forming an inorganic thin film layer on a flexible base material or an organic layer using a glow discharge plasma by a known vacuum deposition method such as a CVD method as described above. The inorganic thin film layer is preferably formed by a continuous deposition process. For example, it is more preferable to continuously form an inorganic thin film layer on a long laminated body while continuously transporting the long laminated body. Specifically, an inorganic thin film layer may be formed while transporting the laminated body from the delivery roll to the wind-up roll. Thereafter, the delivery roll and the wind-up roll may be reversed to transport the laminated body in the opposite direction, and an inorganic thin film layer may be further formed thereon.

[Flexible electronic device]

The present disclosure also provides a flexible electronic device including the laminated body according to an embodiment of the present invention. Examples of the flexible electronic device (flexible display) include liquid crystal display devices, solar cells, organic EL displays, organic EL micro displays, organic EL lighting, and electronic paper, which are required to exhibit higher gas barrier property. The laminated body according to an embodiment of the present invention can be suitably used as a flexible substrate for the flexible electronic device. In a case in which the laminated body is used as a flexible substrate, the device may be formed directly on the laminated body or the device may be formed on another substrate and then the laminated body may be superimposed on the device with an adhesive layer or a pressure sensitive adhesive layer interposed therebetween.

EXAMPLES

Hereinafter, the present disclosure will be described in more detail with reference to Examples, but the present disclosure is not limited to the following Examples. Unless otherwise stated, "%" and "part" in examples are % by mass and parts by mass. The apparatuses, measurement methods, and evaluation methods used in Examples are as follows.

[Film thickness]

(Inorganic thin film layer) In the step of laminating an inorganic thin film layer in Examples and Comparative Examples, the organic layer is marked with an oil-based pen before the inorganic thin film layer is laminated. After the inorganic thin film is laminated, the marked location can be wiped off with a solvent such as ethanol to form a location where the inorganic thin film layer does not exist. The thickness of the inorganic thin film layer was measured by measuring the level difference between the location where the inorganic thin film layer did not exist and the location where the inorganic thin film layer was laminated as usual using a fine shape measuring machine (Surfcorder ET3000 manufactured by Kosaka Laboratory Ltd.) under the following conditions.
Scanning speed: 20 $\mu$m/s
Measuring force: 30 $\mu$N
(Laminated body) The film thickness of the laminated body was measured using a film thickness meter (Dial Gauge Application Measuring Instrument 547-401 manufactured by Mitutoyo Corporation).

[Total light transmittance]

The total light transmittance through the laminated bodies obtained in Examples and Comparative Examples was measured using a direct reading haze computer (Model HGM-2DP) manufactured by Suga Test Instruments Co., Ltd.. The background measurement was performed in a state in which the laminated body was not set, then the laminated body was set on the sample holder, and the measurement was performed to determine the total light transmittance through the laminated body.

[Water vapor transmission rate]

The water vapor transmission rate was measured by a Ca corrosion testing method in conformity with ISO/WD 15106-7 (Annex C) under the conditions of a temperature of 23°C and a humidity of 50% RH.

[Measurement by time-of-flight secondary ion mass spectrometry (TOF-SIMS)]

The ionic strengths of $Si^-$, $C^-$, $O_2^-$, and $CN^-$ were measured at a temperature of 23°C and a humidity of 55% RH by time-of-flight secondary ion mass spectrometry (TOF-SIMS) under the following measurement conditions. The portion from the outermost surface of the laminated bodies of Examples and Comparative Examples on the inorganic thin film layer side to 5 nm was removed by sputtering, and the measurement was performed from the position at 5 nm from the outermost surface on the inorganic thin film layer side in the thickness direction until to reach the flexible base material contained in the base material layer.

(Measurement conditions)

 (1) Instrument: "TOF.SIMS V" manufactured by IONTOF GmbH,
 (2) Primary ion: $Bi^+$,
 (3) Acceleration voltage of primary ion: 25 kV,
 (4) Irradiation ion current: 1.0 pA,
 (5) Pulse frequency of primary ion : 10 kHz,
 (6) Measurement condition: Bunching (high mass resolution) mode, negative ion,
 (7) Measuring range: 100 $\mu$m $\times$ 100 $\mu$m,
 (8) Number of scans: 1 scan/cycle, and
 (9) Flat gun used for charge correction.

<Sputtering conditions>

 (1) Sputter ion: $Cs^+$,
 (2) Acceleration voltage of sputter ion: 1.0 kV,
 (3) Sputter ion current: 50 nA,
 (4) Sputtering zone: 200 $\mu$m $\times$ 200 $\mu$m, and
 (5) Sputtering time: 1.638 seconds.

Surface Lab was used for the data analysis of TOF-SIMS. Mass calibration of the measurement data was performed and the integrated value of peak was calculated for each of the peaks attributed to C ion, CN ion, Si ion, and $O_2$ ion. Thereafter, a depth profile was acquired by graphing the distance (nm) from the surface of the thin film layer on the horizontal axis and the integrated value (ionic strength) of peak of each ion or the ratio of each ion intensity to the intensity of Si ion on the vertical axis.

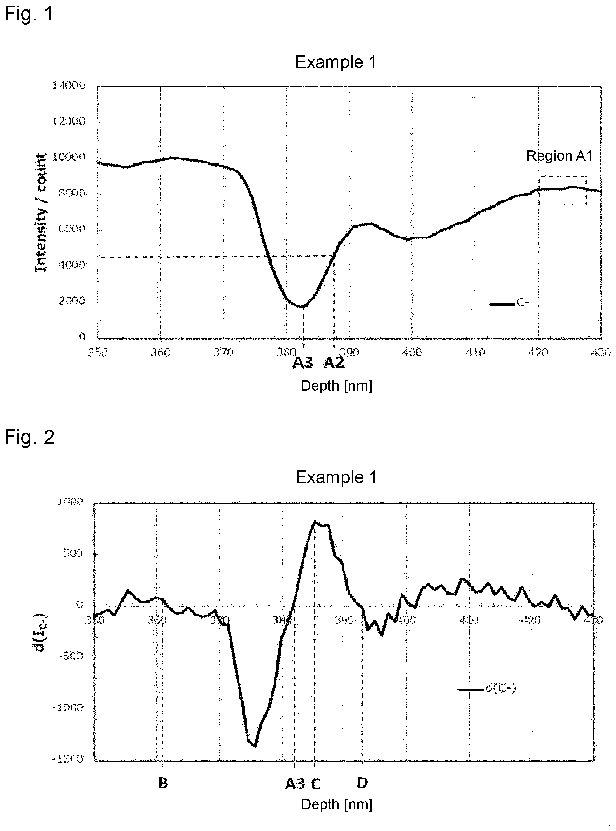

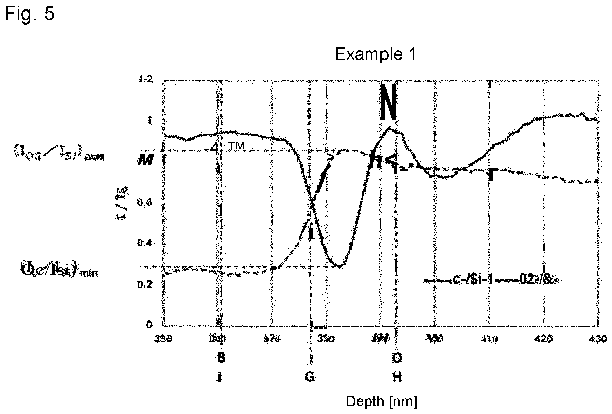

The method for designating the region BD and the region GH using the results measured under the above measurement conditions will be described with reference to Figs. 1 to 5 related to Example 1.

(Method for designating region BD)

The ionic strength curve of $C^-$ acquired as a result of the measurement is illustrated in Fig. 1. In the ionic strength curve illustrated in Fig. 1, and the like, the number of sputterings was converted into the distance (depth) from the outermost surface of the inorganic thin film layer by the method to be described later, and the converted depth was taken as the X-axis. For the region A1 in which the ionic strength value is almost flat in the ionic strength curve, the average ionic strength ($I_{CA1}$) and the absolute value of the coefficient of variation of the ionic strength value were measured, and as a result, $I_{CA1}$ was 8350 and the absolute value of the coefficient of variation was within 5%. The depth that was closest to the region A1 on the surface side of the inorganic thin film layer with respect to the region A1 (in the direction in which the numerical value of the depth is smaller) and exhibited an ionic strength (4175) to be 0.5 times or less the $I_{CA1}$ was denoted as A2 (387 nm). Next, the depth that was closest to A2 on the surface side of the inorganic thin film layer with respect to A2 and exhibited the minimum value was denoted as A3 (382 nm).

Next, the ionic strength of $C^-$ was differentiated to acquire the first-order differential curve of the ionic strength of $C^-$ illustrated in Fig. 2. A3 (382 nm) designated as described above was taken as the reference, and the depth that was closest to A3 on the surface side of the inorganic thin film layer with respect to A3 and had a differential value of 0 or more was denoted as B (361 nm), the depth that was closest to A3 on the base material layer side with respect to A3 (in the direction in which the numerical value of the depth is larger) and exhibited the maximum value $d(I_C)_{max}$ of differential distribution value was denoted as C (385 nm), and the depth that was closest to C on the base material layer side with respect to C and had an absolute value of differential value to be 0.01 times or less the $d(I_C)_{max}$ was denoted as D (393 nm). The region BD was designated in this way. In the laminated body of Example 1, assuming that the film thickness of the inorganic thin film layer was 393 nm and the film thickness corresponds to the number of sputterings from the surface of the inorganic thin film layer to the depth D, the number of sputterings was converted into the depth from the relation of these. Since the measurement in Example 2 and Comparative Example 1 was performed under the same conditions as in Example 1, the number of sputterings was converted into the depth in the same manner as in the above conversion.

(Method for designating region GH and depth J)

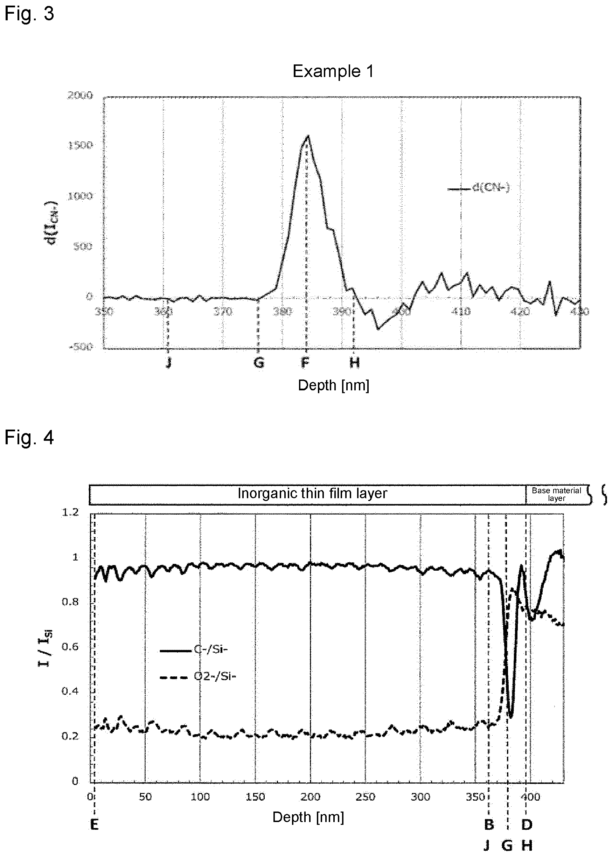

Fig. 3 illustrates the first-order differential curve of the ionic strength of CN⁻ acquired by differentiating the ionic strength of CN⁻ obtained as a result of the measurement.

In the first-order differential curve of the ionic strength of CN⁻ illustrated in Fig. 3, the depth exhibiting the maximum value $d(I_{CN})_{max}$ of the differential distribution value was denoted as F (384 nm). The depth that was closest to F on the surface side of the inorganic thin film layer with respect to F and had an absolute value of differential value to be 0.01 times or less the maximum value $d(I_{CN})_{max}$ was denoted as G (377 nm). The depth that was closest to F on the base material layer side with respect to F and had an absolute value of differential value to be 0.01 times or less the maximum value $d(I_{CN})_{max}$ was denoted as H (393 nm). The region GH was designated in this way. The depth separated from the depth G toward the surface side of the inorganic thin film layer at a distance (16 nm) equal to the distance between the depth G and the depth H was denoted as J (361 nm).

[Adhesive property of laminated body]

The laminated films obtained in Examples and Comparative Examples were each cut into squares of 50 mm × 50 mm and bent one time in a bending diameter of 10 mmφ with the inorganic thin film layer side of the laminated film on the outside in conformity with JIS K 5600-5-1. Next, in conformity with ASTM D5539, eleven cuts reaching the base were made on the test surface (the surface on the inorganic thin film layer side) of the laminated film at 1 mm intervals using a cutter knife to make 100 grids. Cellophane tape (CELLOTAPE (registered trademark) No. 405 (for industrial use) manufactured by NICHIBAN Co., Ltd., adhesive strength: 3.93 N/10 mm) was strongly pressed on the grid portion, and the end of the tape was peeled off at an angle of 60°. In the laminated film after peeling off, the area of the portion that was not peeled off but remained was measured, and the adhesion index was calculated by the following Equation (12). It indicates that the adhesive property is higher as the adhesion index is higher.

[Math.12]

$$\text{Adhesion index} =$$
$$(\text{Area of portion that was not peeled off but}$$
$$\text{remained/Total area of grids}) \times 100\ [\%]\quad(12)$$

[Example 1]

As a flexible base material, a biaxially stretched polyethylene naphthalate film (Q65HWA manufactured by Teijin Film Solutions Limited, thickness: 100 μm, width: 1320 mm, double-sided easy-adhesion treatment) was used. TOMAX (registered trademark) FA-3292 (hereinafter referred to as "composition for organic layer formation 1") manufactured by NIPPON KAKO TORYO CO., LTD. was applied to one side of the base material by a gravure coating method while transporting the flexible base material at a speed of 10 m/min. The solvent in the coating film was evaporated by allowing the base material to pass through a drying oven at 100°C for 30 seconds or longer, and then the composition for organic layer formation 1 was cured by being irradiated with UV to obtain a film in which an organic layer having a thickness of 2.5 μm was laminated on a flexible base material (UV curing condition: Fusion electrodeless UV lamp, 200 mJ/cm²) .

Here, the composition for organic layer formation 1 was a composition containing ethyl acetate as a solvent at 8.1% by mass, propylene glycol monomethyl ether as a solvent at 52.1% by mass, a UV curable oligomer as a solid component at 10% to 20% by mass, silica particles (average primary particle diameter: 20 nm) at 20% to 30% by mass, and a photopolymerization initiator as an additive at 2% to 3% by mass. The UV curable oligomer was a photocurable compound having a (meth)acryloyl group as a polymerizable functional group.

Next, according to the method for manufacturing an inorganic thin film layer and deposition condition 1 to be described below, an inorganic thin film layer was laminated on the surface of the film (thickness: 103 μm, width: 1,320 mm) in which an organic layer was laminated on the flexible base material on the organic layer side to manufacture a laminated film 1.

[Method for manufacturing inorganic thin film layer 1]

In the manufacturing apparatus illustrated in Fig. 6, the magnetic field forming apparatus A1 and the magnetic field forming apparatus A2 are disposed inside the first deposition roll 17 so as to face the outside of the first deposition roll 17 instead of the rotation axis side of the first deposition roll 17 although not illustrated in Fig. 6, and the magnetic field forming apparatus B1 and the magnetic field forming apparatus B2 are disposed inside the second deposition roll 18 so as to face the outside of the second deposition roll 18 instead of the rotation axis side of the second deposition roll 18 although not illustrated in Fig. 6. The magnetic field forming apparatus includes a central magnet extending in the same direction as the extending direction of the first deposition roll 17 and the second deposition roll 18 and an annular external magnet that is disposed to extend in the same direction as the extending direction of the first deposition roll 17 and the second deposition roll 18 while surrounding the central magnet. One ends of the central magnet and the external magnet are fixed by a fixing member so that the external magnet is disposed to surround the central magnet. Here, the fact that the magnetic field forming apparatus is disposed so as to face the outside of the deposition roll instead of the rotation axis side of the deposition roll indicates that the magnetic field forming apparatus is disposed so that the magnetic field forming portion of the magnetic field forming apparatus faces the outside of the deposition roll and the side of the fixing member positioned on the side opposite to the magnetic field forming portion of the magnetic field forming apparatus faces the rotation axis side of the deposition roll.

The magnetic field forming apparatus A1 and the magnetic field forming apparatus B1 are disposed so that the magnetic field forming portion of each of these apparatuses faces the deposition space SP side and these apparatuses are opposed to each other between the two deposition rolls. The magnetic field forming apparatus A2 is disposed at a position where the magnetic field forming apparatus A1 is rotated 90 degrees clockwise around the rotation axis of the first deposition roll 17, and the magnetic field forming apparatus B2 is disposed at a position where the magnetic field forming apparatus B1 is rotated 90 degrees counterclockwise around the rotation axis of the second deposition roll 18. Therefore, the magnetic field forming apparatuses A2 and B2 are each disposed at a position separated from the gas supply pipe farther than the magnetic field forming apparatuses A1 and B1 and the magnetic field forming portions thereof face downward in Fig. 6. An inorganic thin film layer was laminated on an organic layer laminated on a flexible base material using such a manufacturing apparatus. As a specific procedure, as illustrated in Fig. 6, a flexible base material on which an organic layer was laminated was set on the delivery roll 11, a magnetic field was applied between the first deposition roll 17 and the second deposition roll 18 and electric power was supplied to each of the first deposition roll 17 and the second deposition roll 18 to generate plasma by electric discharge. A deposition gas (a mixed gas of hexamethyldisiloxane as a source gas and oxygen gas (which also functioned as a discharge gas) as a reactant gas) was supplied to such a discharge region to perform thin film formation by a plasma enhanced CVD method under the following deposition condition 1, and thus the inorganic thin film layer was laminated on the organic layer laminated on the flexible base material. As the degree of vacuum in the vacuum chamber in the following deposition condition, the value acquired by detecting the pressure in the vicinity of the exhaust port using a diaphragm gauge was adopted.

[Deposition condition 1]

Source gas: Hexamethyldisiloxane (HMDSO)
Amount of source gas supplied: 206 sccm (Standard Cubic Centimeter per Minute, based on 0°C and 1 atm, ml/min)
Reactant gas: Oxygen gas ($O_2$)
Amount of reactant gas supplied: 1,860 sccm (based on 0°C and 1 atm)
Degree of vacuum in vacuum chamber: 1 Pa
Diameter of deposition roll: 195 mm
Applied power from power supply for plasma generation: 1.5 kW
Frequency of power supply for plasma generation: 70 kHz
Transport velocity of film; 6.7 m/min
Number of passes: 14 times

[Example 2]

As a flexible base material, a cycloolefin polymer film (product name "ZEONORFILM (registered trademark) ZF-16" manufactured by ZEON CORPORATION, thickness: 100 $\mu$m, width: 1,320 mm) was used. The composition for organic layer formation 1 was applied to one side of the base material by a gravure coating method while transporting the flexible base material at a speed of 10 m/min. The solvent in the coating film was evaporated by allowing the base material to pass through a drying oven at 100°C for 30 seconds or longer, and then the composition for organic layer formation 1 was cured by being irradiated with UV to obtain a film in which an organic layer having a thickness of 0.9 $\mu$m was laminated on a flexible base material (UV curing condition: Fusion electrodeless UV lamp, 200 mJ/cm$^2$) .

Next, an inorganic thin film layer was laminated on the surface of the film (thickness: 101 $\mu$m, width: 1,320 mm) in which an organic layer was laminated on the flexible base material on the organic layer side to manufacture a laminated film 2 by the same method as the method for manufacturing an inorganic thin film layer except that the following deposition condition 2 was adopted instead of the deposition condition 1.

[Method for manufacturing inorganic thin film layer 2]

An inorganic thin film layer was laminated on an organic layer laminated on a flexible base material using the same manufacturing apparatus as that in Example 1 under the following deposition condition 2. The specific procedure is the same as in Example 1.

[Deposition condition 2]

Source gas: Hexamethyldisiloxane (HMDSO)
Amount of source gas supplied: 186 sccm (Standard Cubic Centimeter per Minute, based on 0°C and 1 atm, ml/min)
Reactant gas: Oxygen gas ($O_2$)
Amount of reactant gas supplied: 1,860 sccm (based on 0°C and 1 atm)
Degree of vacuum in vacuum chamber: 1 Pa
Diameter of deposition roll: 195 mm
Applied power from power supply for plasma generation: 1.5 kW
Frequency of power supply for plasma generation: 70 kHz
Transport velocity of film; 5.7 m/min
Number of passes: 12 times

[Comparative Example 1]

As a flexible base material, a biaxially stretched polyethylene naphthalate film (Q65HWA manufactured by Teijin Film Solutions Limited, thickness: 100 $\mu$m, width: 700 mm, double-sided easy-adhesion treatment) was used. Product name: Aronix (registered trademark) UV-3701 (hereinafter referred to as "composition for organic layer formation 2") manufactured by TOAGOSEI CO., LTD. was applied to one side of the base material by a gravure coating method while transporting the flexible base material at a speed of 10 m/min. The solvent in the coating film was evaporated by allowing the base material to pass through a drying oven at 80°C for 1 minute or longer, and then the composition for organic layer formation 2 was cured by being irradiated with UV to obtain a film in which an organic layer having a thickness of 2 $\mu$m was laminated on a flexible base material (UV curing condition: Fusion electrodeless UV lamp, 30 mJ/cm$^2$).
Next, an inorganic thin film layer was laminated on the surface of the film (thickness: 103 $\mu$m, width: 700 mm) in which an organic layer was laminated on the flexible base material on the organic layer side to manufacture a laminated film 3 by the same method as the method for manufacturing an inorganic thin film layer except that the following deposition condition 3 was adopted instead of the deposition condition 1.

[Deposition condition 3 of inorganic thin film layer]

An apparatus was used in which the magnetic field forming apparatus A1 is disposed inside the first deposition roll 17 so as to face the outside of the deposition roll although not illustrated in Fig. 6, and the magnetic field forming apparatus B1 is disposed inside the second deposition roll 18 so as to face the outside of the deposition roll although not illustrated in Fig. 6 in the manufacturing apparatus illustrated in Fig. 6. Here, the magnetic field forming apparatus A1 and the magnetic field forming apparatus B1 were opposed to each other between the two deposition rolls. An inorganic thin film layer was laminated on an organic layer laminated on a flexible base material using such a manufacturing apparatus under the following deposition condition 3. The specific procedure is the same as in Example 1.

[Deposition condition 3]

Source gas: Hexamethyldisiloxane (HMDSO)
Amount of source gas supplied: 50 sccm (Standard Cubic Centimeter per Minute, based on 0°C and 1 atm, ml/min)
Reactant gas: Oxygen gas ($O_2$)
Amount of reactant gas supplied: 500 sccm (based on 0°C and 1 atm)
Degree of vacuum in vacuum chamber: 1 Pa
Diameter of deposition roll: 139 mm
Applied power from power supply for plasma generation: 1.6 kW
Frequency of power supply for plasma generation: 70 kHz
Transport velocity of film; 0.6 m/min

Number of passes: 2 times

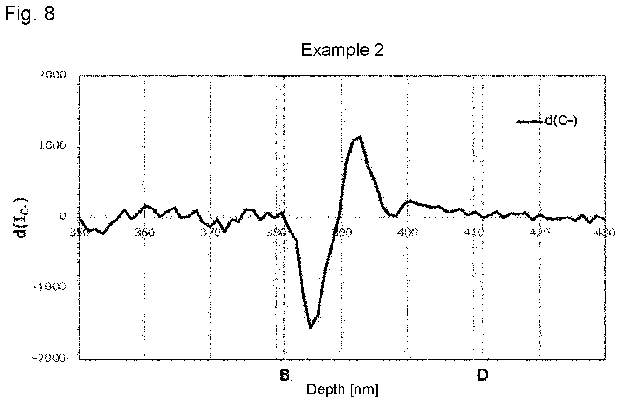

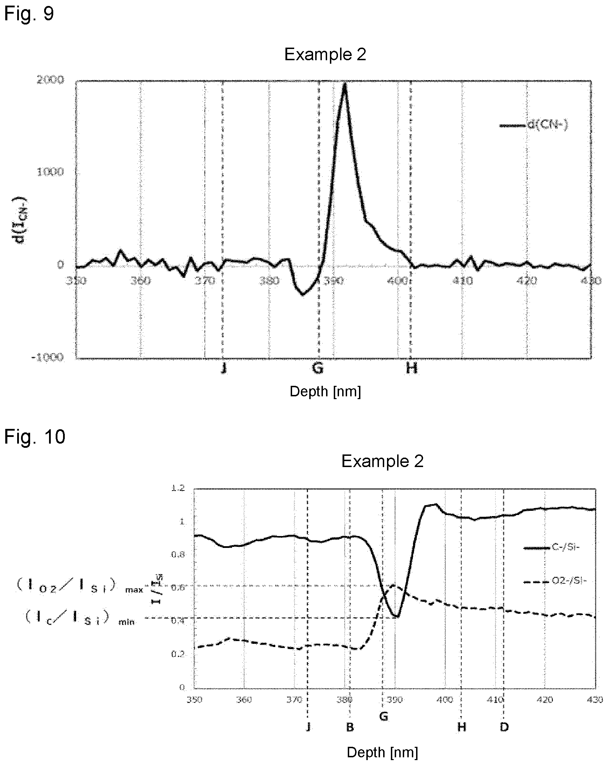

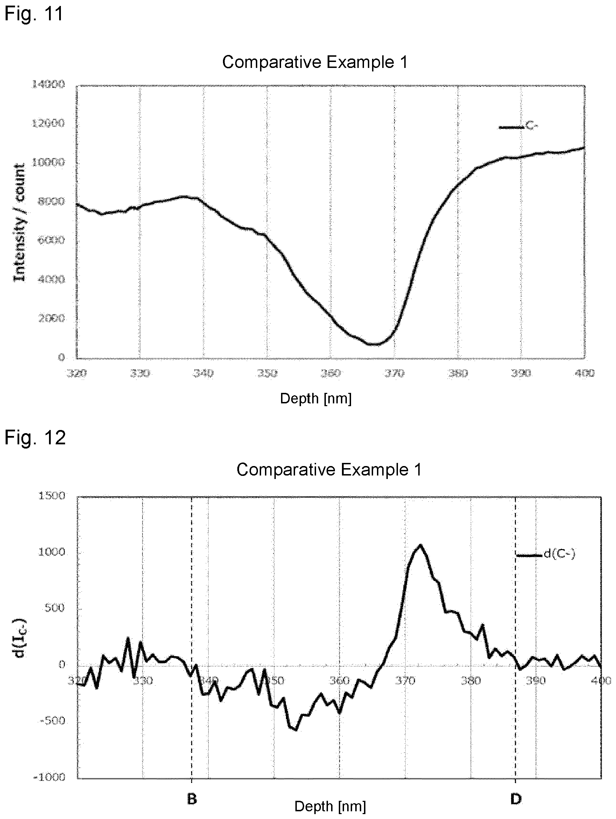

The depth profiles of the laminated films 1 to 3 manufactured as described above were measured using TOF-SIMS. The profile acquired for Example 1 is illustrated in Figs. 1 to 5, the profile acquired for Example 2 is illustrated in Figs. 7 to 10, and the profile acquired for Comparative Example 1 is illustrated in Figs. 11 to 14. The numerical value of each depth and the like are presented in Tables 1 and 2. The coefficient of variation and standard deviation of the $I_{O2}/I_{Si}$ and $I_C/I_{Si}$ values were calculated for the regions EB and EJ in the distribution curves of $I_{O2}/I_{Si}$ and $I_C/I_{Si}$, and the results presented in Table 3 were obtained.

The results of the thickness of inorganic thin film layer, total light transmittance, water vapor transmission rate, and adhesive property for the laminated films 1 to 3 manufactured as described above measured according to the above methods are presented in Table 1 or Table 4.

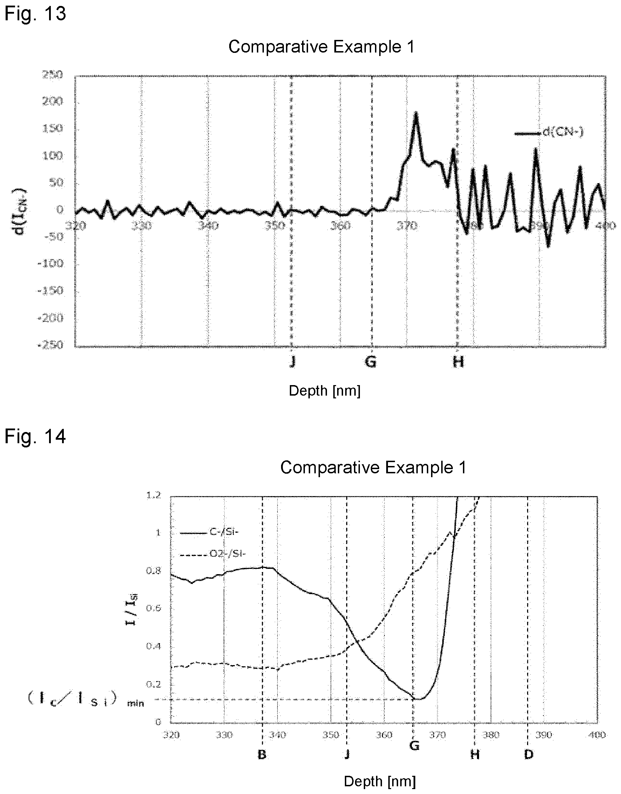

As illustrated in Figs. 4, 5, and 10, it has been confirmed that the distribution curves of $I_{O2}/I_{Si}$ and distribution curves of $I_C/I_{Si}$ measured for the laminated films obtained in Examples 1 and 2 all have a maximum value $(I_{O2}/I_{Si})_{max}$ (maximum value $(I_{O2}/I_{Si})_{maxBD}$ and maximum value $(I_{O2}/I_{Si})_{maxGH}$) and a minimum value $(I_C/I_{Si})_{minBD}$ and a minimum value $(I_C/I_{Si})_{minGH}$ in the regions BD and GH. On the other hand, as illustrated in Fig. 14, the distribution curve of $I_{O2}/I_{Si}$ measured for the laminated film obtained in Comparative Example 1 did not have a maximum value $(I_{O2}/I_{Si})_{max}$ .

[Table 1]

|  | Film thickness of inorganic thin film layer [nm] | Depth [nm] | | | | | |
|---|---|---|---|---|---|---|---|
|  |  | A3 | B | D | G | H | J |
| Example 1 | 393 | 382 | 361 | 393 | 377 | 393 | 361 |
| Example 2 | 411 | 390 | 381 | 411 | 388 | 403 | 373 |
| Comparative Example 1 | 387 | 366 | 337 | 387 | 365 | 377 | 353 |

[Table 2]

|  | Maximum value $(I_{O2}/I_{Si})_{max}$ | | Minimum value $(I_C/I_{Si})$ min | | Distance [nm] |
|---|---|---|---|---|---|
|  | Depth [nm] | Value | Depth [nm] | Value | |
| Example 1 | 383 | 0.866 | 382 | 0.291 | 1 |
| Example 2 | 390 | 0.621 | 391 | 0.431 | 1 |
| Comparative Example 1 | - | - | 366 | 0.128 | - |

[Table 3]

|  | Standard deviation (region EB) | | Standard deviation (region EJ) | |
|---|---|---|---|---|
|  | $I_C/I_{Si}$ | $I_{O2}/I_{Si}$ | $I_C/I_{Si}$ | $I_{O2}/I_{Si}$ |
| Example 1 | 0.016 | 0.020 | 0.016 | 0.020 |
| Example 2 | 0.029 | 0.021 | 0.029 | 0.022 |
| Comparative Example 1 | 0.211 | 0.090 | 0.207 | 0.088 |

[Table 4]

|  | Total light transmittance [%] | Water vapor transmission rate [g/m²/day] | Adhesion index [%] |
|---|---|---|---|
| Example 1 | 90 | $2 \times 10^{-5}$ | 100 |
| Example 2 | 91 | $2 \times 10^{-5}$ | 99 |
| Comparative Example 1 | 90 | $2 \times 10^{-5}$ | 10 |

DESCRIPTION OF REFERENCE SIGNS

| 2 | Base material (film) |
|---|---|
| 11 | Delivery roll |
| 12 | Wind-up roll |
| 13 to 16 | Transport roll |
| 17 | First deposition roll |
| 18 | Second deposition roll |
| 19 | Gas supply pipe |
| 20 | Power supply for plasma generation |
| SP | Space (deposition space) |

**Claims**

1. A laminated body comprising at least a base material layer containing at least a flexible base material and an inorganic thin film layer, wherein a distribution curve of $I_{O2}/I_{Si}$ has at least one maximum value $(I_{O2}/I_{Si})_{maxBD}$ in a region BD between a depth B and a depth D, where
ionic strengths of $Si^-$, $C^-$, and $O_2^-$ are each denoted as $I_{Si}$, $I_C$, and $I_{O2}$ in a depth profile measured from a surface of the laminated body on an inorganic thin film layer side in a thickness direction using a time-of-flight secondary ion mass spectrometer (TOF-SIMS),
an average ionic strength in a region A1 in which an absolute value of a coefficient of variation of an ionic strength value on a base material layer side is within 5% is denoted as $I_{CA1}$, a depth that is closest to the region A1 on a surface side of the inorganic thin film layer with respect to the region A1 and exhibits an ionic strength to be 0.5 times or less the $I_{CA1}$ is denoted as A2, and a depth that is closest to A2 on a surface side of the inorganic thin film layer with respect to A2 and exhibits a minimum value is denoted as A3 in an ionic strength curve of $C^-$, and
a depth that is closest to A3 on a surface side of the inorganic thin film layer with respect to A3 and has a differential value of 0 or more is denoted as B, a depth that is closest to A3 on a base material layer side with respect to A3 and exhibits a maximum value $d(I_C)_{max}$ of differential distribution value is denoted as C, and a depth that is closest to C on a base material layer side with respect to C and has an absolute value of differential value to be 0.01 times or less the $d(I_C)_{max}$ is denoted as D in a first-order differential curve of ionic strength of $C^-$.

2. The laminated body according to claim 1, wherein the maximum value $(I_{O2}/I_{Si})_{maxBD}$ is 0.4 or more.

3. The laminated body according to claim 1 or 2, wherein a standard deviation of $I_{O2}/I_{Si}$ is 0.07 or less in a region EB between a depth E and the depth B in a distribution curve of $I_{O2}/I_{Si}$, where a depth at 5 nm on the base material layer side from an outermost surface on the inorganic thin film layer side is denoted as E.

4. The laminated body according to any one of claims 1 to 3, wherein a distribution curve of $I_C/I_{Si}$ has at least one minimum value $(I_C/I_{Si})_{minBD}$ in a region BD between the depth B and the depth D.

5. The laminated body according to any one of claims 1 to 4, wherein the minimum value $(I_C/I_{Si})_{minBD}$ is 0.8 or less.

6. The laminated body according to any one of claims 1 to 5, wherein a standard deviation of $I_C/I_{Si}$ is 0.15 or less in a region EB between the depth E and the depth B of the distribution curve of $I_C/I_{Si}$.

7. The laminated body according to any one of claims 1 to 6, wherein a distance between a depth exhibiting the maximum value $(I_{O2}/I_{Si})_{maxBD}$ and a depth exhibiting the minimum value $(I_C/I_{Si})_{minBD}$ is 0.7 times or less a distance of the region BD.

8. A laminated body comprising at least a base material layer containing at least a flexible base material and a layer containing a component having a urethane bond and an inorganic thin film layer, wherein a distribution curve of $I_{O2}/I_{Si}$ has at least one maximum value $(I_{O2}/I_{Si})_{maxGH}$ in a region GH between a depth G and a depth H, where ionic strengths of $CN^-$, $Si^-$, $C^-$, and $O_2^-$ are each denoted as $I_{CN}$, $I_{Si}$, $I_C$, and $I_{O2}$ in a depth profile measured from a surface of the laminated body on an inorganic thin film layer side in a thickness direction using a time-of-flight secondary ion mass spectrometer (TOF-SIMS), and

a depth that exhibits a maximum value $d(I_{CN})_{max}$ of differential distribution value is denoted as F, a depth that is closest to F on a surface side of the inorganic thin film layer with respect to F and has an absolute value of differential value to be 0.01 times or less the maximum value $d(I_{CN})_{max}$ is denoted as G, and a depth that is closest to F on a base material layer side with respect to F and has an absolute value of differential value to be 0.01 times or less the maximum value $d(I_{CN})_{max}$ is denoted as H in a first-order differential curve of ionic strength of $CN^-$.

9. The laminated body according to claim 8, wherein the maximum value $(I_{O2}/I_{Si})_{maxGH}$ is 0.4 or more.

10. The laminated body according to claim 8 or 9, wherein a standard deviation of $I_{O2}/I_{Si}$ is 0.07 or less in a region EJ between a depth E and a depth J in a distribution curve of $I_{O2}/I_{Si}$, where a depth at 5 nm on the base material layer side from an outermost surface on the inorganic thin film layer side is denoted as E and a depth that is separated from the depth G toward the surface side of the inorganic thin film layer at a distance equal to a distance between the depth G and the depth H is denoted as J.

11. The laminated body according to any one of claims 8 to 10, wherein a distribution curve of $I_C/I_{Si}$ has at least one minimum value $(I_C/I_{Si})_{minGH}$ in a region GH between the depth G and the depth H.

12. The laminated body according to claim 11, wherein the minimum value $(I_C/I_{Si})_{minGH}$ is 0.8 or less.

13. The laminated body according to any one of claims 8 to 12, wherein a standard deviation of $I_C/I_{Si}$ is 0.15 or less in a region EJ between the depth E and the depth J of the distribution curve of $I_C/I_{Si}$.

14. The laminated body according to any one of claims 8 to 13, wherein a distance between a depth exhibiting the maximum value $(I_{O2}/I_{Si})_{maxGH}$ and a depth exhibiting the minimum value $(I_C/I_{Si})_{minGH}$ is 0.7 times or less a distance of the region GH.

15. A flexible electronic device comprising the laminated body according to any one of claims 1 to 14.

16. A method for manufacturing the laminated body according to any one of claims 1 to 14, the method comprising at least a step of forming an inorganic thin film layer on a base material by supplying a deposition gas to a space between a first deposition roll and a second deposition roll that are disposed in a vacuum chamber to generate discharge plasma while transporting the base material using the first deposition roll and the second deposition roll, wherein a first magnetic field forming apparatus is disposed in each deposition roll of the first deposition roll and the second deposition roll and one or more additional magnetic field forming apparatuses are disposed at a position separated from a deposition gas supply portion farther than the first magnetic field forming apparatus.

Fig. 1

Example 1

Fig. 2

Example 1

Fig. 3

Example 1

Fig. 4

Fig. 5

Example 1

Fig. 6

Fig. 7

Example 2

Fig. 8

Example 2

Fig. 9

## Example 2

Fig. 10

## Example 2

Fig. 11

Comparative Example 1

Depth [nm]

Fig. 12

Comparative Example 1

Depth [nm]

Fig. 13

Comparative Example 1

Depth [nm]

Fig. 14

Comparative Example 1

Depth [nm]

**INTERNATIONAL SEARCH REPORT**

| International application No. |
|---|
| PCT/JP2019/041168 |

| A.   CLASSIFICATION OF SUBJECT MATTER |
|---|
| B32B 9/00(2006.01)i; C23C 16/42(2006.01)i<br>FI: B32B9/00 A; C23C16/42<br>According to International Patent Classification (IPC) or to both national classification and IPC |

| B.   FIELDS SEARCHED |
|---|
| Minimum documentation searched (classification system followed by classification symbols)<br>B32B9/00; C23C16/42 |

Documentation searched other than minimum documentation to the extent that such documents are included in the fields searched

| | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

| C.   DOCUMENTS CONSIDERED TO BE RELEVANT | | |
|---|---|---|
| Category* | Citation of document, with indication, where appropriate, of the relevant passages | Relevant to claim No. |
| X<br><br>A | JP 2015-131473 A (KONICA MINOLTA, INC.) 23.07.2015 (2015-07-23) paragraphs [0012], [0022], [0035], [0064], [0078], [0096], [0098], [0185], [0190], [0191], [0247]-[0253], table 1, fig. 1, 2 | 1-15<br><br>16 |
| A | WO 2018/168671 A1 (KONICA MINOLTA, INC.) 20.09.2018 (2018-09-20) paragraphs [0075], [0077], [0083], [0164], table 1, paragraph [0202], table 2 | 1-16 |
| A | JP 2012-82468 A (SUMITOMO CHEMICAL CO., LTD.) 26.04.2012 (2012-04-26) paragraphs [0006], [0054], [0061], [0062], [0063], [0068], [0071], [0072], fig. 1 | 1-16 |
| A | JP 2016-183356 A (KONICA MINOLTA, INC.) 20.10.2016 (2016-10-20) paragraphs [0028]-[0038], fig. 2-6 | 1-16 |
| A | WO 2016/152488 A1 (KONICA MINOLTA, INC.) 29.09.2016 (2016-09-29) paragraph [0181], fig. 2-9 | 1-16 |

☒   Further documents are listed in the continuation of Box C.      ☒   See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>    09 January 2020 (09.01.2020) | Date of mailing of the international search report<br>    21 January 2020 (21.01.2020) |
|---|---|
| Name and mailing address of the ISA/<br>    Japan Patent Office<br>    3-4-3, Kasumigaseki, Chiyoda-ku,<br>    Tokyo 100-8915, Japan | Authorized officer<br><br><br>Telephone No. |

Form PCT/ISA/210 (second sheet) (January 2015)

**EP 3 871 876 A1**

## INTERNATIONAL SEARCH REPORT

| | International application No. |
|---|---|
| | PCT/JP2019/041168 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2018-89950 A (KOBE STEEL, LTD.) 14.06.2018 (2018-06-14) entire text | 1-16 |

Form PCT/ISA/210 (continuation of second sheet) (January 2015)

**INTERNATIONAL SEARCH REPORT**
Information on patent family members

| International application No. |
|---|
| PCT/JP2019/041168 |

| Patent Documents referred in the Report | Publication Date | Patent Family | Publication Date |
|---|---|---|---|
| JP 2015-131473 A | 23 Jul. 2015 | (Family: none) | |
| WO 2018/168671 A1 | 20 Sep. 2018 | (Family: none) | |
| JP 2012-82468 A | 26 Apr. 2012 | (Family: none) | |
| JP 2016-183356 A | 20 Oct. 2016 | WO 2015/025782 A1 paragraphs [0028]-[0038], fig. 2-6 | |
| WO 2016/152488 A1 | 29 Sep. 2016 | (Family: none) | |
| JP 2018-89950 A | 14 Jun. 2018 | CN 108146047 A entire text KR 10-2018-0064296 A | |

Form PCT/ISA/210 (patent family annex) (January 2015)

**REFERENCES CITED IN THE DESCRIPTION**

**Patent documents cited in the description**

- JP 2016068383 A

- WO 2013146964 A